# EUROPEAN PATENT SPECIFICATION

(11) **EP 3 295 567 B1**
(45) Date of publication and mention of the grant of the patent: **26.12.2018**
(21) Application number: 15726009.2
(22) Date of filing: 08.05.2015
(51) Int. Cl.: H03M 7/30, H04L 12/26, G06F 15/18, G06F 17/30, G06K 9/62

(54) **PATTERN-BASED DATA COLLECTION FOR A DISTRIBUTED STREAM DATA PROCESSING SYSTEM**
MUSTERBASIERTE DATENSAMMLUNG FÜR EIN VERTEILTES DATENSTROMVERARBEITUNGSSYSTEM
COLLECTE DE DONNÉES À L'AIDE DE MODÈLES POUR UN SYSTÈME DE TRAITEMENT DE FLUX DE DONNÉES DISTRIBUÉ

(43) Date of publication of application: 21.03.2018
(73) Proprietor: Telefonaktiebolaget LM Ericsson (publ), 164 83 Stockholm (SE)
(72) Inventor: MANZANO MACHO, David, E-28041 Madrid (ES); LAFUENTE ALVAREZ, Luis Maria, E-28047 Madrid (ES)
(74) Representative: Ericsson
(86) International application number: PCT/EP2015/060185
(87) International publication number: WO 2016/180436

(56) References cited:
- US-A1- 2013 082 851
- US-A1- 2013 156 190

## Description

### [Technical Field]

The present disclosure generally relates to the field of stream data processing and, more specifically, to a technique for efficiently collecting data in a distributed stream data processing system that employs a network to convey one or more data streams.

### [Background]

So-called "big data" has encouraged organizations to collect as much data as possible in order to perform data analytics on the collected data. Data volumes and the diversity of new data sources are exploding everywhere. More than ever before, many businesses have come to rely on the data collected from a plurality of sources in order to take the best decision possible based on the information available. Time is becoming a critical factor for decisions makers and this has increased the demand for processing streaming data in real-time to leverage insights with minimum delay for business operations. Nowadays, everything that happens in a company can be recorded, collected, transmitted to a stream data analytics platform, and collated with data collected from a plurality of data sources, to make it all available as a real-time stream. Data should be collected as soon as it is available from the site where it has been produced and transferred to the place where it will be stored, correlated with other data sources, analysed and/or brokered to some other final destination.

However, data collection is costly and consumes a lot of resources, especially when the data volume is high and there are multiple data sources that produce the data to be collected. The lower the reporting time period for each of the data producers is, the greater the problem of collecting such an amount of data will be. There is a need for collecting and transmitting data in the most efficient way possible.

As an illustrative example, in Machine to Machine scenarios, new applications are increasing the volume, variety and velocity of data that can be used for many different purposes such as tracking location, heath monitoring, etc. Another example is event-based monitoring applications, which have gained renewed interest and have the potential to scale to hundreds of data sources and possibly thousands of user clients. Event-based monitoring is used, among other possible applications, to obtain and/or execute rule-based actions in real-time taking into account the data that have previously been analysed at any time by the system. A device (a data producer) such as a sensor or smart meter might record events by means of some data (such as temperature, CPU load, energy consumption by an appliance, etc.) that are transmitted through a network from the data producer to an application or server (a data consumer) that will correlate, analyse and produce meaningful information from the data from time to time or in real-time (using, for instance, stream data processing technology). Although the majority of the devices may report data rather infrequently, many other devices (such as smart meters, tracking position devices, etc.) release data in almost real-time, increasing the volume of data transmitted and the utilization of resources.

As a yet further example, in the case of communication networks, traffic loads are increasing continuously due to the growing use of smartphones and applications. Identifying potential bottlenecks early helps operators continuously maintain good quality of services (QoS) for their users. It is becoming challenging to efficiently manage network capacity to guarantee the QoS for subscribers, which makes it important to obtain more information about what is happening in the network, with no delay. Real-time contextual data about how the network is performing at any time (involving data from several nodes and related bearers, capacity, etc.) allows systems managers to proactively monitor and improve customer experience. Such intelligent applications require stream data collected from multiple sources with various latencies to be correlated and analysed in order to reveal actionable insights that might be useful for maintaining the required QoS.

In all these cases, obtaining data from multiple sources is costly in terms of network bandwidth and other computational resources that are involved in the process. The challenge increases with the increasing number of high throughput data producers, such as sensors or smartphones. Furthermore, reducing the reporting time period increases the volume of data to be transmitted through the network and consequently the load on the server responsible for their collection and processing. There is a need to identify and handle, in an efficient way, which data are released from data producers and how these data are transmitted. A reduction in the data exchanged between the data producers and the data consumers will also reduce the chance of overloading situations and will release some extra network capacity that can be used for some other purposes. Moreover, streams are typically of a very high rate and have to be transferred continuously. When compared to the abundant processing power provided by a large number of servers, network bandwidth is the bottleneck in such a context. When applications fail or degrade performance then the system must react intelligently to reduce the workload in the entire system.

While an approach requiring the application to release messages immediately may not be problematic in small-scale systems, in larger systems the need to simultaneously update information from all the components can provide a significant impediment. In order to conserve bandwidth and reduce storage and processing requirements, storing and transmitting data in an efficient way is more than desirable.

US 2013/082851 A1 discloses a method for compressing data on a PCI bus. A dictionary of patterns is maintained. When data is transferred and a pattern in the dictionary matches the data, the index of the pattern instead of the data is transferred. Partial matches are possible, a bitmap of which parts of a pattern match is transferred. Non-matching parts of the data are transferred after the pattern index.

### [Summary]

The present inventors have identified short-comings in various conventional approaches to solving the problems identified above. For example, one possible solution that allows controlling data loads is load shedding. Load shedding discards data until enough processing/storage resources become available. However these methods present several shortcomings. Firstly, in some systems it is not possible to shed data because all requests need to be handled (i.e. no information loss is acceptable). Secondly, they are implemented in the data consumer side; as this is only responsible for deciding which data will be shed and for how long, load shedding does not prevent data producers from sending data across the network, which leads to a misuse of the network, both in terms of bandwidth and processing.

Another conventional approach is to delay, for a period of time, the reporting of new events. Thus, data producers store some data locally, within this time window, until reporting is enabled again. The advantage is obvious; as long as the data is not being sent out, less processing is being done by system. However, this approach is unfeasible when data needs to be released in real-time. In these scenarios, the value of the stored data may rapidly decline over time, meaning that when it is finally ready to be transmitted, it might not be useful at all.

Another approach aims at constraining the data producers' reporting capabilities until data consumers are ready to handle the load. However, this approach has several inconveniences. Data are usually discarded on a time-basis fashion, without considering if they are really relevant for the data consumer or not. Besides, some data producers do not support any filtering mechanism at all (e.g. the aforementioned time-basis one or any other based on the application of certain filtering rules).

The present inventors have devised a scheme of collecting data records in a distributed stream data processing system that exploits the tendency in some practical applications for data records in the flow to follow a pattern. The embodiments of the present invention described herein allow the amount of data that is to be transmitted between data sources and data consumers to be diminished, thereby freeing up valuable network resources to process other traffic.

A communication system according to an embodiment of the present invention comprises a first network node and a second network node, where the first network node is arranged to transmit a flow of data records to the second network node via a network, and the second network node includes a data record processing module arranged to receive and process the data records. In the embodiment, data records of the flow are acquired and analysed to determine whether they match a part of a pattern of one or more patterns each defining a respective sequence of data records. When the acquired data records match part of one of the patterns, the matching pattern is identified, and an indication of the matching pattern is generated along with at least one transmission control signal for the first network node to prevent the first network node from transmitting to the second network node remaining data records in the flow that follow the acquired data records and whose number is equal to the number of data records in the remaining part of the matching pattern. The remaining part of the matching pattern being the part of the sequence of data records of the pattern other than the part found to match the acquired data records. The communication system of the embodiment also has a pattern handler that includes a data store which stores the one or more patterns, the pattern handler being communicatively coupled to the data record processing module via a communication path that is separate from the network and thus uses none of the network's resources. In response to the indication of the matching pattern, the pattern handler predicts the remaining data records using the pattern of the stored patterns that is indicated by the indication, and provides the predicted data records to the data record processing module via the communication path. In this way, the data record processing module can be provided with predicted data records that are the same (or substantially the same) as those that would have been transmitted via the network, at the mere cost of communicating the aforementioned indication of the matching pattern or the at least one transmission control signal across the network, which would, in general, place a much smaller burden on the available network resources than the transmission of data records corresponding to those that have been predicted. Valuable network resources can thus be made available for handling other network traffic, without compromising on the accuracy of data records provided to the data record processing module of the second network node.

More specifically, the present inventors have devised a communication system comprising a first network node and a second network node, wherein the first network node is arranged to transmit a flow of data records to the second network node via a network, and the second network node comprises a data record processing module arranged to receive and process the data records. The communication system further comprises a controller for controlling the transmission of data records by the first network node to the second network node, the controller comprising: an acquisition module operable to acquire data records of the flow of data records; a pattern recognition module arranged to determine whether the data records acquired by the acquisition module match a part of a pattern of one or more patterns each defining a respective sequence of data records and, when the acquired data records match part of a pattern of the one or more patterns, to identify which of the one or more patterns the acquired data records match; and a control signal generator module arranged to generate, when the pattern recognition module has identified a pattern matching the acquired data records, an indication of the matching pattern and at least one transmission control signal for the first network node to prevent the first network node from transmitting to the second network node remaining data records in the flow that follow the acquired data records and whose number is equal to the number of data records in the remaining part of the matching pattern. The remaining part of the matching pattern being the part of the sequence of data records of the pattern other than the part found to match the acquired data records. The communication system further comprises a pattern handler comprising a data store that stores the one or more patterns, the pattern handler being communicatively coupled to the data record processing module via a communication path that is separate from the network and responsive to the indication of the matching pattern to predict the remaining data records using the pattern of the stored patterns that is indicated by the indication, and provide the predicted data records to the data record processing module via the communication path.

The present inventors have further devised a controller for use in a communication system, the communication system comprising: a first network node and a second network node, wherein the first network node is arranged to transmit a flow of data records to the second network node via a network, and the second network node comprises a data record processing module arranged to receive and process the data records; and a pattern handler comprising a data store that stores one or more patterns each defining a respective sequence of data records, the pattern handler being communicatively coupled to the data record processing module via a communication path that is separate from the network, wherein the pattern handler is responsive to an indication of a pattern to predict data records using a pattern of the stored patterns that is indicated by the indication, and provide the predicted data records to the data record processing module via the communication path. The controller is arranged to control the transmission of data records by the first network node to the second network node, and comprises: an acquisition module operable to acquire data records of the flow of data records; a pattern recognition module arranged to determine whether the data records acquired by the acquisition module match part of a pattern of the one or more patterns and, when the acquired data records match part of a pattern of the one or more patterns, to identify which of the one or more patterns the acquired data records match; and a control signal generator module arranged to generate, when the pattern recognition module has identified a pattern matching the acquired data records, at least one transmission control signal for the first network node to prevent the first network node from transmitting to the second network node remaining data records in the flow that follow the acquired data records and whose number is equal to the number of data records in the remaining part of the matching pattern, and an indication of the matching pattern to cause the pattern handler to predict the remaining data records and provide the predicted data records to the data record processing module via the communication path). The remaining part of the matching pattern being the part of the sequence of data records of the pattern other than the part found to match the acquired data records.

The inventors have further devised a network node operable to receive a flow of data records that has been transmitted by a second network node via a network, the network node comprising: a data record processing module arranged to receive and process the data records; a data store that stores one or more patterns each defining a respective sequence of data records; a controller for controlling the transmission of data records by the second network node. The controller comprises an acquisition module operable to acquire data records of the flow of data records; a pattern recognition module arranged to determine whether the data records acquired by the acquisition module match part of a pattern of the one or more patterns stored in the data store and, when the acquired data records match part of a pattern of the one or more patterns, to identify which of the one or more patterns the acquired data records match; and a control signal generator module arranged to generate, when the pattern recognition module has identified a pattern matching the acquired data records, an indication of the matching pattern and at least one transmission control signal for the second network node to prevent the second network node from transmitting remaining data records in the flow that follow the acquired data records and whose number is equal to the number of data records in the remaining part of the matching pattern. The remaining part of the matching pattern being the part of the sequence of data records of the pattern other than the part found to match the acquired data records. The network node further comprises a pattern handler responsive to the indication of the matching pattern to predict the remaining data records using the pattern of the stored patterns that is indicated by the indication of the matching pattern, and provide the predicted data records to the data record processing module.

The present inventors have further devised a method of controlling the transmission of data records in a communication system comprising: a first network node and a second network node, wherein the first network node is arranged to transmit a flow of data records to the second network node via a network, and the second network node comprises a data record processing module arranged to receive and process the data records; and a pattern handler comprising a data store that stores one or more patterns each defining a respective sequence of data records, the pattern handler being communicatively coupled to the data record processing module via a communication path that is separate from the network, wherein the pattern handler is responsive to an indication of a pattern to predict data records using a pattern of the stored patterns that is indicated by the indication, and to provide the predicted data records to the data record processing module via the communication path. The method comprises: acquiring data records of the flow of data records; determining whether the acquired data records match a part of a pattern of the one or more patterns; and generating, when the acquired data records have been determined to match a part of a pattern of the one or more patterns: (i) at least one transmission control signal for the first network node to prevent the first network node from transmitting to the second network node remaining data records in the flow that follow the acquired data records and whose number is equal to the number of data records in the remaining part of the matching pattern, the remaining part of the matching pattern being the part of the sequence of data records of the pattern other than the part found to match the acquired data records; and (ii) an indication of the matching pattern for use by the pattern handler to predict the remaining data records.

The present inventors have further devised a computer program product, comprising a non-transitory computer-readable storage medium or a signal, carrying computer program instructions which, when executed by a processor, cause the processor to perform at least one of the methods set out above.

### [Brief Description of the Drawings]

Embodiments of the invention will now be explained by way of example only, in detail, with reference to the accompanying figures, in which:
Fig. 1 is a schematic illustrating a communication system according to a first embodiment of the present invention;
Fig. 2 is a schematic illustrating components of the controller 700 shown in Fig. 1;
Fig. 3 is a block diagram illustrating an example of signal processing hardware that may be configured to function as a controller or a pattern handler according to an embodiment of the present invention;
Fig. 4 is a flow diagram illustrating processing operations performed by the controller in the first embodiment of the present invention;
Fig. 5 is a flow diagram showing details of the pattern monitoring process S50 that is performed in the flow diagram of Fig. 4;
Fig. 6 is a flow diagram summarising the processing operations performed by the controller in the first embodiment of the present invention;
Fig. 7 is a flow diagram illustrating a pattern learning process performed by the pattern learning module in the first embodiment of the present invention;
Fig. 8 is a flow diagram illustrating processing operations performed by the pattern handler in the first embodiment of the present invention; and
Fig. 9 is a schematic illustrating a communication system according to a second embodiment of the present invention.

### [Detailed Description]

### [Embodiment 1]

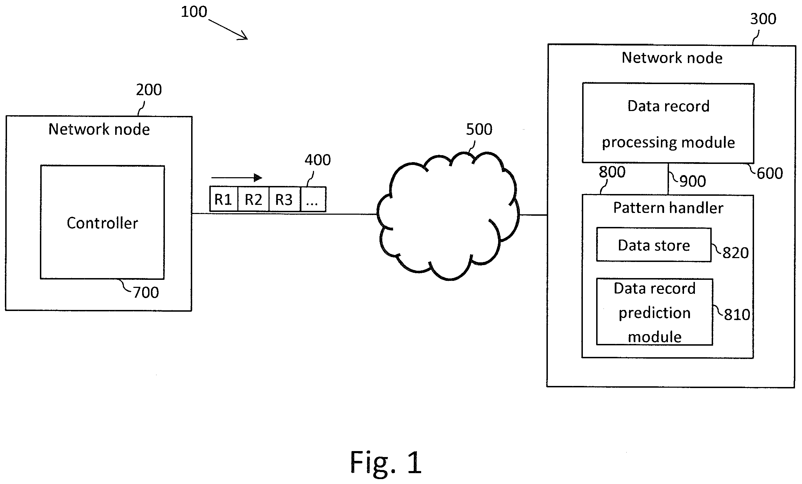

Figure 1 is a schematic illustration of a communication system 100 according to the first embodiment of the present invention. The communication system 100 comprises a first network node 200 and a second network node 300, the first network node 100 being configured to transmit a flow of data records 400 to the second network node 300 via a computer network 500 such as the Internet. The communication system 100 can thus be regarded as a distributed stream data processing system.

The second network node 300 is provided at a data consumer site and comprises a data record processing module 600 which is configured to receive the data records and process them in any way required by the data consumer. The second network node 300 may alternatively function as a forwarding element that forwards data records received thereby to a data consumer site or another intervening forwarding element.

In the present embodiment, the first network node 200 is configured to process data records received from a data producer site (not shown) in any suitable or desirable way and to forward the processed data records towards the second node 300 via the network 500. However, the first network node 200 may alternatively generate the data records itself. Depending on the use case and the scenario, the information contained in the data records may change. For example, in the context of a smart metering application, a data record may provide an indication of electricity consumption measured at any time by the smart meter. As another example, in the context of a performance monitoring application for a network management system, the data record may be related to any key performance indicator (KPI), CPU consumption, bandwidth utilisation, etc. provided by the system being monitored at any time and sent towards the location of the performance monitoring application server.

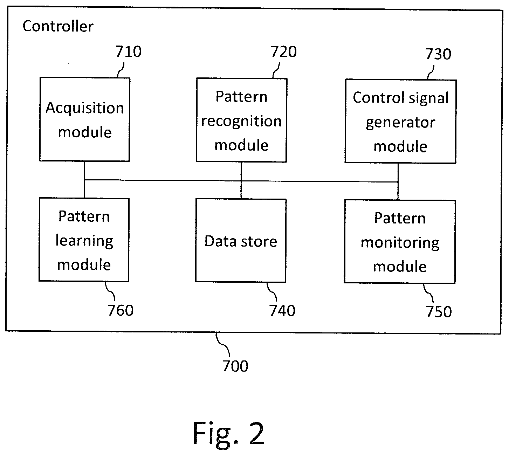

The first network node 200 comprises a controller 700 for controlling the transmission of data records by the first network node 200 to the second network node 300. Functional components of the controller are illustrated in Fig. 2. The controller 700 of the present embodiment comprises an acquisition module 710, a pattern recognition module 720, and a control signal generator module 730.

The controller 700 may further comprise a data store 740 that stores one or more patterns each defining a respective sequence of data records, where each of the one or more patterns is stored in association with a respective pattern identifier that identifies the pattern, as well as an indication of the pattern's accuracy (which, as will be explained in the following, will depend on how many times departures from the pattern have been observed during prior operation of the system). In the present embodiment, a plurality of patterns is stored in the data store 740, each in association with a respective pattern identifier and accuracy indication. The controller 700 may, as in the present embodiment, also include a pattern monitoring module 750 and a pattern learning module 760. The functionalities of these components of the controller 700 will be described below in detail.

Referring again to Fig. 1, the second network node 300 also includes a pattern handler 800 having a data record prediction module 810 that predicts data records based on a pattern of (in general) one or more patterns of data records that are stored in a data store 820 of the pattern handler 800. In the present embodiment, the data store 820 stores a plurality of patterns, each in association with a corresponding pattern identifier, where the patterns and associated pattern identifiers in data store 820 are the same as the patterns and pattern identifiers that are stored in data store 740 of the controller 700. The patterns in the data store 820 may be input by a user familiar with patterns of data records that are likely to appear in the data record flow 400. Alternatively, the controller 700 may be configured to update the data store 820 via the network 500 to store the same one or more patterns and associated pattern identifier(s) as the data store 740 (regardless of whether these one or more patterns have been learned by the pattern learning module 760 or entered into the data store 740 by the user), as will be explained further in the following.

The pattern handler 800 is communicatively coupled to the data record processing module 600 via a communication path 900 that is separate from the network and, more specifically, internal to the second network node 300. Where, as in the present embodiment, the functions of the data record processing module 600 and the pattern handler 800 are implemented in common data processing hardware, the communication path 900 is internal to that hardware. However, in other possible implementations, wherein the data record processing module 600 and the pattern handler 800 are implemented in separate hardware, the communication path 900 may, for example take the form of a data bus or a direct data link that is separate from the network 500 and thus uses none of its resources. As will be explained in the following, the pattern handler 800 is configured to predict data records under certain circumstances and to provide the predicted data records to the data record processing module 600 via the communication path 900. The pattern handler 800 is also responsible for analysing the validity of the existing patterns and providing feedback about the accuracy of the patterns in use to the controller 700 in order to update the way in which patterns are learned and recognized.

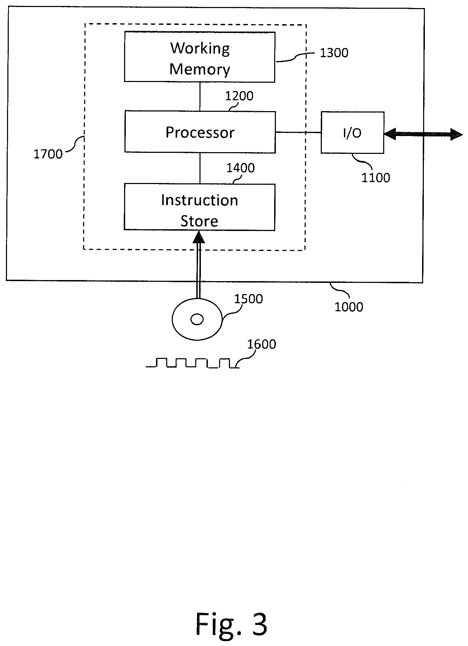

Regarding the physical implementation of the controller 700 and the pattern handler, this could be done in a number of different ways. For example, a programmable signal processing apparatus of the general kind shown schematically in Fig. 3 could be programmed using techniques well known to those skilled in the art to provide the functionality of one or more of the components of the controller 700 shown in Fig. 2. A programmable signal processing hardware of this kind could be programmed to function as the pattern handler 800 and, additionally or alternatively, also the data record processing module 600 and one or more other components of the second network node 300.

The signal processing apparatus 1000 comprises a communications module 1100, a processor 1200, a working memory 1300, and an instruction store 1400 storing computer-readable instructions which, when executed by the processor 1200, cause the processor 1200 to perform the processing operations hereinafter described to generate at least one transmission control signal for the first network node 200 and a pattern indicator based on data records acquired from the flow 400 and the one or more patterns stored in the data store 740 (when implementing the functionality of the controller 700) or to predict data records based on stored one or more patterns and a received pattern indicator (when implementing the functionality of the data handler 800).

The instruction store 1400 is a data storage device which may comprise a non-volatile memory, for example in the form of a ROM, a magnetic computer storage device (e.g. a hard disk) or an optical disc, which is pre-loaded with the computer-readable instructions. Alternatively, the instruction store 1400 may comprise a volatile memory (e.g. DRAM or SRAM), and the computer-readable instructions can be input thereto from a computer program product, such as a computer-readable storage medium 1500 (e.g. an optical disc such as a CD-ROM, DVD-ROM etc.) or a computer-readable signal 1600 carrying the computer-readable instructions.

The working memory 1300 functions to temporarily store data to support the processing operations executed in accordance with the processing logic stored in the instruction store 1400. As shown in Fig. 3, the communications module 1100 is arranged to communicate with the processor 1200 so as to render the signal processing apparatus 1000 capable of processing received signals and communicating its processing results.

In the present embodiment, the combination 1700 of the processor 1200, working memory 1300 and the instruction store 1400 (when appropriately programmed by techniques familiar to those skilled in the art) together constitute the components of the controller 700 shown in Fig. 2. The combination 1700 could additionally or alternatively be configured to perform the operations of the pattern handler 800 that are described herein.

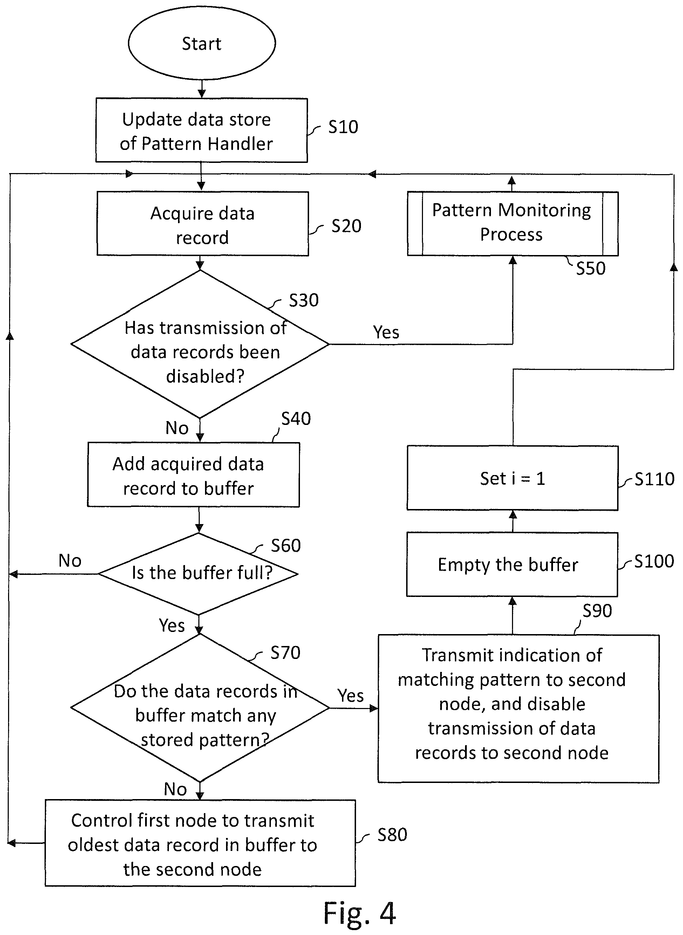

The processing operations performed by the controller 700 to control the transmission of data records via the network 500 will now be described with reference to Fig. 4.

At start-up, the controller 700 may, as in the present embodiment, access its data store 740 to acquire the patterns stored therein and update the data store 820 of the pattern handler 800 via the network 500 to store the same patterns and associated pattern identifiers as the data store 740 of the controller 700. The pattern handler 800 stores each received pattern in the data store 820 in association with the pattern identifier that identifies that pattern.

Each of the stored patterns may be a sequence of actual data records that is known to repeat from time to time in the data flow. However, the stored pattern may, as in the present embodiment, be provided in the more compact form of a mathematical function that models the repeating sequence of data records. This function, together with an indication of the sequence length (which defines the time-frame of the pattern), can be used to reconstruct the repeating sequence of data records. Regardless of their form, the patterns may be entered directly by a user who is familiar with the behaviour of the data record source(s) and/or they may be learned autonomously by the pattern learning module 760 in the manner described below.

In step S20, the acquisition module 710 acquires a data record that is to be transmitted by the first network node 200 towards the second network node 300. During the repeated execution of step S20 that is described below, the acquisition module 710 acquires each data record from the flow, in turn. However, in other embodiments, the acquisition module 710 may alternatively acquire only some of the data records (e.g. every j^{th} data record in the flow, where j is an integer).

In step S30, the acquisition module 710 determines whether the control signal generator module 730 has disabled the transmission of data records by the first network node 200. As will be explained below, the transmission of data records by the first network node 200 is disabled when the pattern recognition module 720 has determined that the data records that are to be transmitted appear to be following a known pattern. If the transmission of data records by the first network node 200 has not been disabled, the process proceeds to step S40, otherwise it proceeds to the pattern monitoring process S50 described below.

In step S40, the acquisition module 710 stores the data record acquired in step S20 in, e.g. a First-In, First-Out (FIFO) buffer. Then, in step S60, the acquisition module 710 determines whether the FIFO buffer is full. In general, the FIFO buffer has the capacity to store N data records, where N is an integer greater than or equal to two. By way of example, N = 4 in the present embodiment. If the FIFO buffer is not yet full, the process loops back to step S20, the next data record in the flow is acquired and, in a repeat of step S40, added to the FIFO buffer. By the repeated performance of step S20 to S60, the FIFO buffer is filled up, one data record at a time, to store a sequence of N = 4 data records that follow one another in the data record flow 400 (i.e. the ith, (i+1)th, (i+2)th and (i+3)th data records in the flow).

Once the FIFO buffer has been filled up, the process proceeds to step S70, where the pattern recognition module 720 determines whether the N = 4 data records that have been acquired match a part of a pattern of the patterns that are stored in the data store 740. In other words, the pattern recognition module 720 determines whether the sequence of acquired data records appears, in the same form or with data record values that are the same to within a predetermined tolerance (e.g. 2%, 5% or 10%), in any part (preferably at the beginning) other than a concluding part of a sequence of data records that has been constructed using any of the patterns stored in the data store 740. Thus, the pattern recognition module 720 attempts to model the acquired data records using at least some of the stored patterns, looking for a pattern that provides a satisfactory fit to the acquired data records. The goodness of fit for each pattern considered may be determined in any suitable way known to those skilled in the art. If the acquired data records are determined in this way to match any of the stored patterns, the pattern recognition module 720 determines the pattern identifier of the matching pattern, i.e. the pattern identifier associated with the pattern which the acquired data records have been found to follow and which data records subsequent to those acquired might be expected to also follow.

In case the pattern recognition module 720 determines in step S70 that the acquired data records match a part of each of two or more of the patterns stored in the data store 740, it may, as in the present embodiment, select from those candidate patterns the pattern that is indicated in the data store 740 to have the highest accuracy. In case there are two or more matching patterns that are currently indicated to have the same accuracy (or in case accuracy data is not available or not yet available) but one of those matching patterns defines a shorter sequence of data records than each of the one or more other matching patterns, the pattern recognition module 720 preferably selects the shortest pattern as the matching pattern that is being followed by the acquired data records. This selection rule is based on the inventors' finding that patterns defining shorter sequences of data records are more likely to be consistently followed than patterns defining longer sequences of data records.

If the pattern recognition module 720 identifier a pattern matching the acquired data records in step S70, the process proceeds to step S90, otherwise it proceeds to step S80. In step S80, the control signal generator module 730 controls the first network node 200 to serialise (i.e. appropriately format for transmission through the network 500) and transmit the first of the data records to enter the FIFO buffer (i.e. the "oldest" data record in the buffer) to the second network node 300. The process then loops back to step S20 and then on to step S40, in which the FIFO buffer is replenished to store the next data record from the flow 400 that immediately follows that previously added to the FIFO buffer. In this way, the controller 700 continues to look for a pattern that matches the data records in the flow 400, in the meantime causing the first network node 200 to forward data records to the second network node 300 via the network 500.

When the pattern recognition module 720 identifies a pattern matching the acquired data records then, in step S90, the control signal generator module 730 generates and transmits to the pattern handler 800, via the network 500, a message comprising the pattern identifier of the matching pattern that was determined by the pattern recognition module 720 in step S70. In addition, the control signal generator module 730 disables the transmission of data records by the first network node 200 by generating at least one transmission control signal for the first network node 200 to prevent the first network node 200 from transmitting to the second network node 300 remaining data records in the flow that follow the acquired data records, the number of the remaining data records that are not be transmitted to the second network node 300 being equal to the number of data records in the remaining part of the matching pattern. Thus, the data records that are expected to complete the matching pattern are not transmitted via the network 500 and, instead, the pattern identified associated with the matching pattern is transmitted to the pattern handler 800. As will be explained further below, the pattern handler 800 is arranged to respond to receipt of the pattern identifier by retrieving the pattern from the data store 820 which is associated with the received pattern identifier, to use the retrieved pattern to predict the remaining data records, and to provide the predicted data records to the data record processing module 600 via the communication path 900.

More specifically, the control signal generator module 730 may, as in the present embodiment, generate in step S90 a first ("stop") signal to prevent the first network node 200 from transmitting data records to the second network node 300, and subsequently a second ("start") signal to cause the first network node 200 to resume transmitting data records, where the time interval between the transmission of the first and second signals is set to allow the pattern handler 800 to predict and provide the remaining data records of the matching pattern to the data record processing module 600. However, in other embodiments, the control signal generator module 730 may generate in step S90 a single transmission control signal for the first network node 200, which specifies the number of data records whose transmission to the second network node 300 is to be prevented.

Furthermore, the generation of the transmission control signal(s) and the indication of the matching pattern by the control signal generator module 730 may be made conditional on the network being close to a congested state. In this case, the control signal generator module 730 may be arranged to determine whether usage of network bandwidth available for communication between the first network node 200 and the second network node 300 exceeds a predetermined level, and to generate the indication of the matching pattern and the at least one transmission control signal when the determined usage exceeds the predetermined level.

In step S100, the acquisition module 710 empties the FIFO buffer and, in step S110, sets a counter "i" used by the pattern monitoring module 720 as hereinafter described to 1. The process then loops back to step S20, where the acquisition module 710 acquires the next data record from the flow 400.

In some embodiments, the data record source(s), which provide, over time, the data records that are to be transmitted by the first network node 200 to the second network node 300, may be certain to provide some of their data records in sequences that never deviate from the stored patterns. In these scenarios, once acquired data records are determined to follow one of the stored patterns, it is certain that subsequent data records in the flow 400 will continue to follow the matching pattern. In these cases, the controller 700 may control the first network node 200 to simply discard remaining data records in the flow 400. that follow the acquired data records and whose number is equal to the number of data records in the remaining part of the matching pattern (i.e. the part of the sequence of data records of the pattern other than the part found to match the acquired data records in step S70).

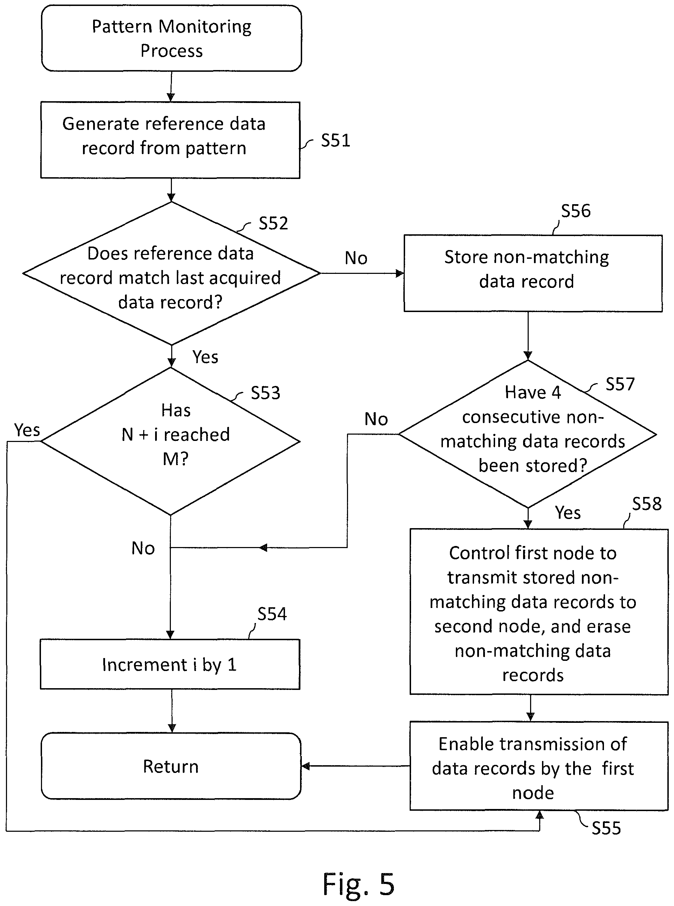

However, the present embodiment is configured to cater for more unpredictable data record sources, whose data records may deviate from the pattern they had been following. In order to ensure that such deviations are not overlooked by the pattern handler 800, the controller 700 of the present embodiment comprises a pattern monitoring module 750 as shown in Fig. 2, which monitors data records while the transmission of data records by the first network node 200 to the second network node 300 is disabled to look for any significant deviations from the matching pattern, and causes any deviant data records (as well as subsequent data records from the flow 400) to be transmitted to the second network node 300 via the network 500. The pattern monitoring process in S50 will now be described with reference to Fig. 5.

In step S51, the pattern monitoring module 750 generates a reference data record that is the (N + i)^{th} data record of the sequence of data records defined by the pattern that was identified in step S70. Then, in step S52, the pattern monitoring module 750 determines whether the reference data record matches the data record acquired in the last performance of step S20 (whose transmission has been prevented by the transmission control signal generated by the control signal generator module 720 in step S90). In other words, the pattern monitoring module 750 determines in step S52 whether the reference data record value is the same as, or within a tolerance band (e.g. ± 2%, 5% or 10%) of, the value of the data record acquired in the last performance of step S20.

If the pattern monitoring module 750 determines there to be a match in step S52, this provides new feedback for the pattern learning module 760 (described in more detail below) about the validity of the pattern, and the process proceeds to step S53, where the pattern monitoring module 750 determines whether N + i has reached M, which is the number of data records in the sequence defined by the matching pattern. If N + i has not reached M, then the counter "i" is incremented by 1 in step S54, and the process then loops back to step S20 in Fig. 4, where the next data record from the flow 400 is acquired. On the other hand, if N + i has reached M, then all of the acquired data records have followed the identified pattern, and the pattern accuracy level stored in the data store 740 in association with the matching pattern is modified to reflect the successful following of the matching pattern. In this case, the process proceeds to step S55, in which the pattern monitoring module 750 causes the control signal generator module 730 to enable the first network node 200 to transmit data records to the second network node 300. The process then loops back to step S20 in Fig. 4, and the pattern recognition module begins a new search for a matching pattern, with data records being transmitted across the network 500 to the second network node 300 until a matching pattern has been identified, as described above.

However, if the pattern monitoring module 750 determines there not to be a match in step S52, then the process proceeds to step S55, where the non-matching acquired data record is stored by the pattern monitoring module 750. Then, in step S57, the pattern monitoring module 750 determines whether a predetermined number (in this example, four, although one, two, three or a number greater than four could alternatively be chosen) of consecutive non-matching acquired data records have been stored. If not, then the process proceeds to step S54. However, if the pattern monitoring module 750 determines that four consecutive non-matching acquired data records have been stored, this indicates that the acquired data records have deviated significantly from their expected values (i.e. the values that would be expected if the acquired data records had continued to follow the identified pattern), and the process proceeds to step S58. In step S58, the pattern monitoring module 750 causes the control signal generator module 730 to control the first network node 200 to transmit to the second network node 300 the four stored data records whose transmission to the second network node 300 had been prevented and which were determined not to follow the identified pattern. The process then proceeds to step S55, where the transmission of data records by the first network node 200 is enabled so that data records from the flow 400 subsequent to the four non-matching data records can be transmitted to the second network node 300 via the network 500.

Where the pattern monitoring module 750 determines that four consecutive non-matching acquired data records have been stored, this indicates a failure in the definition of the pattern in use. This may be investigated by the pattern learning module 760 (described in more detail below), which can decide if the affected pattern needs to be updated or even disabled to prevent future inaccuracies. The decision will vary according to the statistical relevance of the detected failure. If it has just happened the first time, the decision may be to wait until further evidence about the failure is collected. This depends on the nature of the application in which the pattern-based event reporting system is used. If guaranteed accuracy is required, the failure will impose an update in the pattern if possible or otherwise the pattern will be disabled, and the failure will be fed back to the pattern learning module 760 to learn new similar patterns better in future closely-related situations.

In the present embodiment, the pattern monitoring module 750 requires four consecutive acquired data records to differ from their respective reference data records by more than a predetermined amount (e.g. ± 2%, 5% or 10%, as noted above). However, in a variant of this embodiment, the pattern monitoring module 750 may be configured to determine that at least one data record whose transmission has been prevented does not follow the identified pattern when each of the at least one data record differs from the corresponding reference data record by at least a respective predetermined amount. Thus, in general, the tolerance bands for the first, second, third and fourth consecutive data records in the above embodiment need not be the same. For example, in an embodiment where small, short-lived departures from the matching pattern are acceptable but more rapid and pronounced departures are not, the finding of a first non-matching acquired data record may require a larger tolerance band to be used in the assessment of the next acquired data record and, where that next acquired data record is also found not to follow the pattern, a yet larger tolerance band to be used in the assessment of the next acquired data record, and so on.

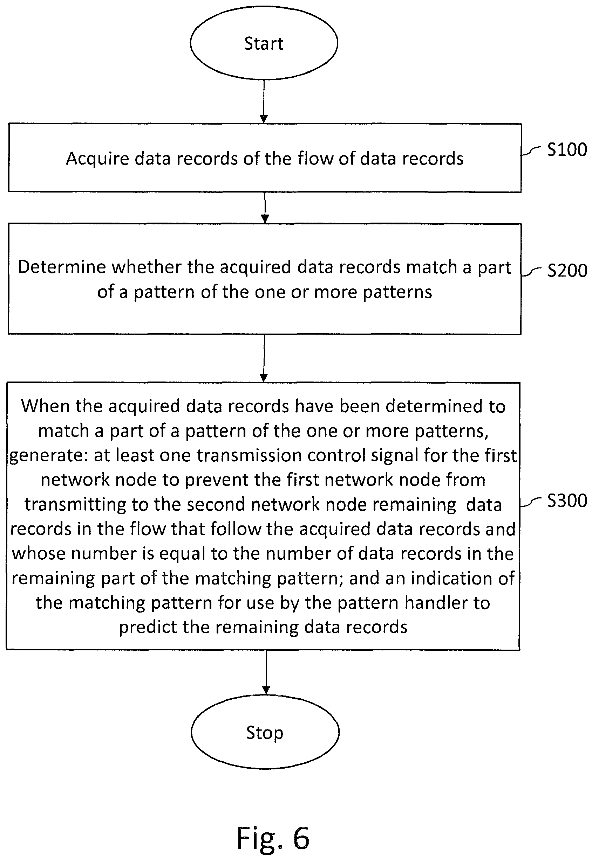

In summary, the controller 700 performs a method of controlling the transmission of data records in the above-described communication system that comprises the key steps shown in the flow diagram of Fig. 6. Namely, in step S100, the controller 700 acquires data records of the flow of data records 400. In step S200, the controller 700 determines whether the acquired data records match a part of a pattern of the one or more patterns. When the acquired data records have been determined to match a part of a pattern of the one or more patterns, the controller 700 generates, in step S300, at least one transmission control signal for the first network node 200 to prevent the first network node 200 from transmitting to the second network node 3C0 remaining data records in the flow that follow the acquired data records and whose number is equal to the number of data records in the remaining part of the matching pattern. The controller 700 also generates in step S300 an indication of the matching pattern for use by the pattern handler 800 to predict the remaining data records.

As noted above, the controller 700 comprises a pattern learning module 760, which can operate in the parallel with other components of the controller 700 in order to learn new patterns and supplement the data store 740 with the new patterns that have been found in the data record flow 400. During its operation, the pattern learning module 760 receives the flow of data records 400 and searches for an occurrence of a repeating sequence of data records that repeats at least once in the flow of data records 400. When a repeating sequence of data records has been found, the pattern learning module 760 generates a pattern defining the repeating sequence of data records and stores the generated pattern in association with a corresponding pattern identifier as one of the stored patterns and associated pattern identifier in the second data store 740. The pattern learning module 760 also transmits the generated pattern and the associated pattern identifier to the pattern handler 800 via the network 500 for storage as one of the patterns and associated pattern identifier in the data store 820. The pattern learning module 760 may discard any patterns that are rarely followed by acquired data records.

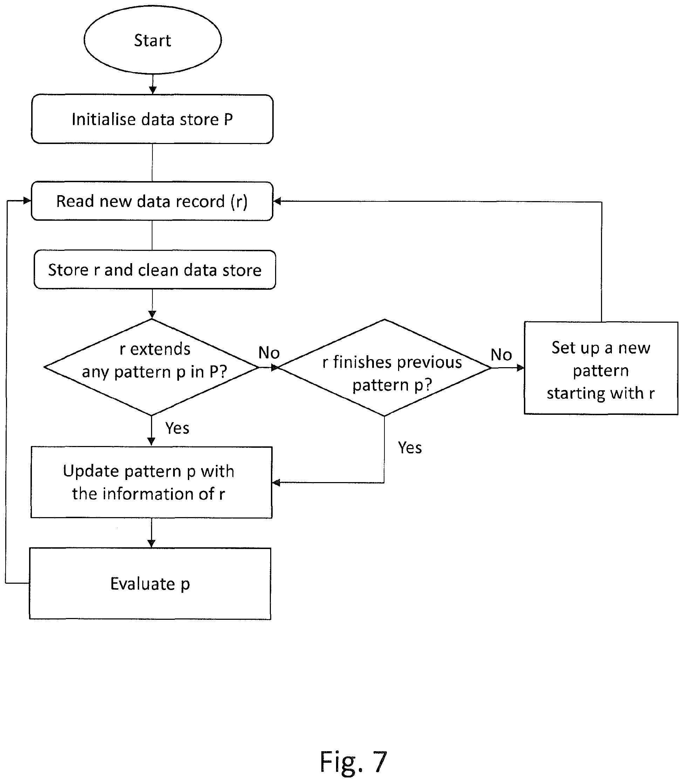

The pattern learning module 760 may follow the workflow shown in Fig. 7. Every new record is analysed together with others acquired before. The number of data records stored is affected by the expected minimum validity time that new patterns should have and by the configuration provided by the second network node 300 in terms of the quality of the data that it expects to get executing the patterns. The new data record is later compared with the existing patterns and, if it extends the information contained in any of the patterns, that pattern will be updated with the new data record. A data record may also mean the end-point for a previously detected pattern, and the starting point for a new candidate pattern. When this happens, the previous pattern is evaluated and a new candidate pattern is set up.

In the pattern learning process, every new data record is analysed together with the data records collected previously, looking for possible patterns or to extend any of the current patterns with the new data record. Any of the following possibilities may occur:
1. If the data record does not extend the information contained in any of the existing patterns, this may mean that the new data record starts a new pattern. This is verified by analysing the data records that follow the data record, and determining whether the data record and the surrounding data records in arrival time really constitute a new pattern or not.
2. The data record extends one or more existing patterns. The information from the new data record is incorporated into any of the existing patterns.
3. The data record does not match the pattern that is already active. In this case, the data record is sent towards the pattern handler 800, the active pattern is deactivated, as described above. The active pattern needs to be updated. The update process may involve several situations. One possibility is that the active pattern is deactivated to prevent the same failure happening in the future. Another possibility is to set up a new pattern with the part of the pattern that was successfully detected until this moment, and remove the rest from the pattern description.

The pattern learning module 760 of the present embodiment provide new patterns (that describe the data records analysed so far) and update the existing patterns to keep their accuracy as high as possible. The pattern learning module 760 may offer several modes of operation. The mode of operation can be selected by the data consumer system through the pattern handler 800. The modes of operation may include:
a) No error mode: this means that patterns will not be applied for a period of time due to some application requirements. This may happen when the application, at the data consumer site, must guarantee completely the accuracy of the results.
b) Overload prevention mode: this changes the way in which pattern are built, spanning the validity time period of the patterns as much as possible. This mode of operation looks for patterns that are valid for a longer period of time, reducing the number of messages sent across the network 500.
c) Normal operation: patterns are built with the highest accuracy possible, meaning that the validity time period will be shorter.

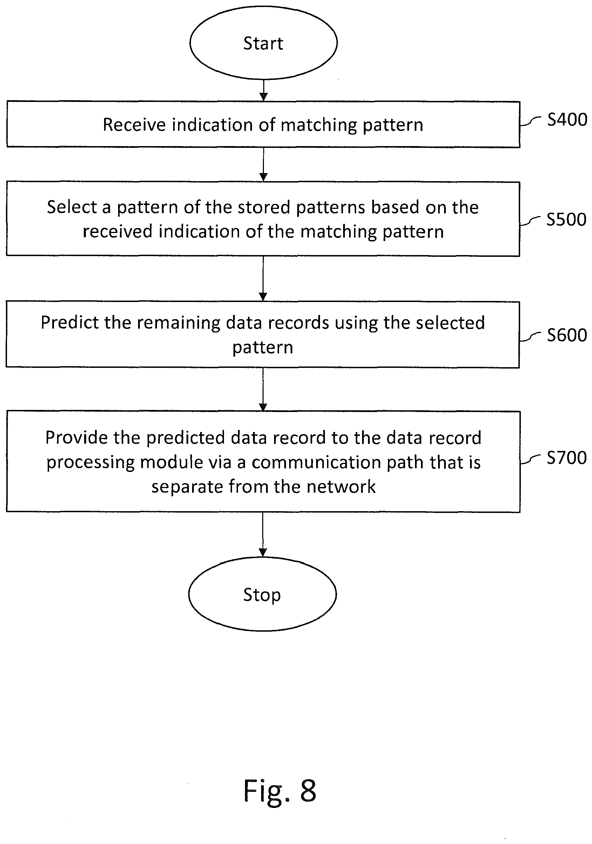

In the present embodiment, the pattern handler 800 is operable in a forwarding mode to de-serialise any data records it receives from the first network node 200 via the network 500 and forward the de-serialised data records to the data record processing module 600. However, when the pattern handler 800 receives the indication of the matching pattern from the control signal generator module 730, the pattern handler switches to operating in a data record prediction mode, as will now be described with reference to Fig. 8.

In step S400, the pattern handler 800 receives the indication of the matching pattern generated by the control signal generator module 730. More particularly, the pattern handler 800 receives the pattern identifier transmitted by the control signal generator module 730 in step S90 of Fig. 4. In this way, the pattern handler 800 is informed that, as long as the identified pattern remains valid, no further data records will be received via the network 500, and that the identified pattern should be used to predict data records that are to be fed to the data record processing module 600. In step S500, the data record prediction module 810 selects a pattern of the patterns stored in the data store 820 based on the received pattern identifier. Then, in step S600, the data record prediction module 810 predicts the remaining data records using the selected pattern. In other words, the data record prediction module 810 uses the selected pattern to reconstruct the sequence of data records that are described by that pattern. Finally, in step S700, the data record prediction module 810 provides the predicted data records to the data record processing module 600 via the communication path 900.

The time span of each pattern is continuously checked to detect if it remains valid or needs to be updated. After the data record prediction module 810 has predicted the final data record in the sequence of data records defined by the indicated pattern, the pattern handler 800 reverts to operating in the aforementioned forwarding mode. However, up to that point, the pattern handler continues to operate in the data record prediction mode (predicting data records and providing them to the data record processing module 600), unless a data record is received from the first network node 200 via the network 500. When a data record is received under these circumstances (i.e. before the remaining data records of the identified pattern have all been predicted by the data record prediction module 810), the data record prediction module 810 responds by terminating its operation in the data record prediction mode, and resumes operating in the forwarding mode. In this way, the data record processing module 600 is fed accurately predicted data records up to the point when the deviation occurs, and is then fed actual data records that have been transmitted via the network 500 and appropriately de-serialised, in place of predicted data records that would not accurately reflect the data records which deviate from the (previously) matching pattern.

The pattern handler 800 may analyse, based on feedback that may be provided by a data consumer system connected to the second network node 300 the pattern accuracy, and send back to the controller 700 the corresponding insights. These insights may be used to reinforce the pattern learning process or to update how patterns are detected, for instance, the validity time period for patterns like the one being analysed.

The operations of the controller 700 and pattern handler 800 may be synchronised in any suitable way to ensure that the data record processing module 600 seamlessly transitions between receiving data records that have been transmitted from the first network node 200 via the network 500, and predicted data records that have been generated by the data record prediction module 810, with no data records being lost or duplicated during the transition. For example, these components may operate on the basis of a common clock signal provided via the network 500, with e.g. the acquisition of each data record and its processing by the pattern monitoring module 750 in S50 being timed to substantially coincide with the prediction of the corresponding data record by the data record prediction module 810.

### [Embodiment 2]

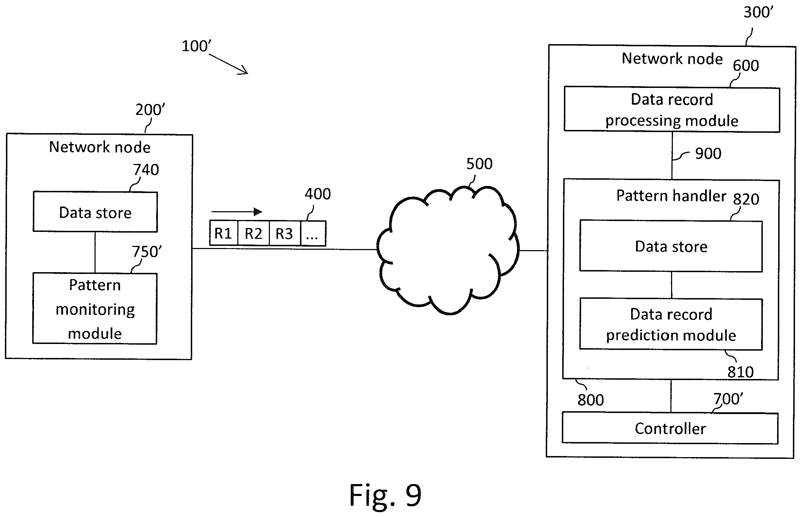

In the above-described first embodiment, the controller 700 is provided as part of the first network node 200 (where it might be provided as a plug-in, if possible) while the pattern handler 800 is provided as part of the second network node 300. However, these components may be deployed in many other ways in the communication system. For example, the controller 700 may alternatively be provided as a stand-alone device in the network 500 (or a component of any intervening node or other component of the network 500), which eavesdrops on traffic being transmitted from the first network node 200 to the second network node 300 to acquire transmitted data records, and performs the above-described processes of interrupting the transmission of data records through the network that are found to follow a known pattern, and causing the data records whose transmission has been withheld to be predicted and passed to the second network node 300 by the pattern handler 800. In the present embodiment, the controller is provided as part of the second network node 300', as illustrated in Fig. 9. Deploying the pattern-based functionality at the second network node 300' may make it possible to grasp a richer view of the whole system and, therefore, the patterns may prove to be more insightful. The second embodiment has many features in common with the first embodiment, and the description of these common features will not be repeated here. However, how the present embodiment differs from the first embodiments will now be described.

The controller 700' of the second embodiment differs from that of the first embodiment in that it does not comprise the data store 740 that stores the patterns, pattern identifiers and accuracy levels as described above. Instead, the controller 700' of the present embodiment (and, more specifically, its pattern recognition module) is arranged to access the data store 820 of the pattern handler 800 and determine whether the data records from the received data record flow 400 that have been acquired by the acquisition module match part of a pattern of the patterns stored in the data store 820. Similarly, the pattern learning module of the controller 700' is configured to store the new patterns it generates (together with the associated pattern identifier) in the data store 820 as one of the stored pattern and pattern identifier combinations.

The first network node 200' may, as in the present embodiment, comprise a second data store, which store the same information as the data store 740 of the first embodiment and is therefore labelled with a like numeral in Fig. 9. Where the first network node 200' comprises the data store 740, the pattern learning module of the controller 700' is preferably arranged to transmit the pattern it generates together with the associated pattern identifier to the first network node 200 via the network 500 for storage as one of the patterns and associated pattern identifier in the second data store 740.

Furthermore, in the present embodiment, the control signal generator of the controller 700' is configured to transmit the transmission control signal(s) it generates to the first network node 200' via the network 500 (instead of internally, within a node, as in the case of the first embodiment). The control signal(s) may be the same as described above with reference to the first embodiment. Alternatively, the control signal generator module may, as in the present embodiment, be arranged to transmit, as the at least one control signal, the indication of the matching pattern to the first network node 200' via the network 500, the indication comprising the pattern identifier associated with the matching pattern. In this example, the first network node 200' is responsive to the receipt of the pattern identifier to stop transmitting data records to the second network node 300', to use the pattern identifier to identify the associated pattern stored in the second data store 740, to use the identified pattern to determine the number of data records whose transmission to the second network node 300' is to be prevented, and to transmit data records that follow the determined number of data records whose transmission to the second network node 300' is to be prevented such that the second network node 300' receives said transmitted data records after the remaining data records have been predicted and provided to the data record processing module 600.

The first network node 200' may, as shown in Fig. 9, also include a pattern monitoring module 750 which is the same as the pattern monitoring module 750 of the controller 700 of the first embodiment, and thus functions as described above.

### [Modifications and Variations]

Many modifications and variations can be made to the embodiments described above.

For example, the order of some of the process steps in Figs. 4 and 5 may be changed. In the case of Fig. 4, the order in which steps S90 to S110 are performed may be varied, for example.

In the above-described embodiments, the flow of data records 400 takes the exemplary form of a single stream of data records, as shown in Figs. 1 and 8. However, in other embodiments, the flow of data records 400 may comprise two or more parallel streams of data records e.g. from multiple data record sources, and each of the one or more patterns may define respective parallel sequences of data records. In these alternative embodiments, the pattern recognition module 720 may be arranged to determine whether data records of a segment of the flow acquired by the acquisition module 710 match part of a pattern of the one or more patterns by comparing data records in each of the streams in the segment with a part of a corresponding one of the sequences of data records in the pattern, and determining that the data records in the segment match part of the pattern when the data records in each of the streams in the segment match the data records in the part of the corresponding one of the sequences of data records in the pattern. In this way, the pattern matching techniques described in the first and second embodiments may be extended to two-dimensional patterns that can occur in data record flows comprising a plurality of data record streams, which may originate from different data record sources (e.g. sensors).

In the above-described embodiments, the pattern handler 800 is arranged to receive data records from the first network node 200 and forward the received data records to the data record processing module 600. In these embodiments, it is therefore possible to configure the pattern handler 800 to interpret the receipt of a data record before the remaining data records of the matching pattern have been predicted as an indication that a data record whose transmission by the first network nods has been prevented does not follow/match the identified pattern being used for data record prediction. In these embodiments, the transmission of at least one data record by the first network node 200 may be sufficient to cause the pattern handler 800 to stop predicting the remaining data records and to revert to passing received data records to the data record processing module 600. However, in other embodiments, the pattern handler may be configured not to receive any data records and to instead start and stop predicting data records and passing them to the data record processing module 600 under instruction of the controller 700. In such alternative embodiments, the pattern handler 800 may be arranged to stop predicting data records in response to a stopping signal, and the pattern monitoring module 750 may be arranged, when at least one data record whose transmission has been prevented is determined not to follow the identified pattern, to cause the control signal generator 730 to generate and transmit the stopping signal via the network 500 to stop the pattern handler 800 predicting data records, and to control the first network node 200 to transmit to the second network node 300 the at least one data record whose transmission had been prevented and which was determined not to follow the identified pattern, such that the data record processing module 600 receives said data records instead of the corresponding predicted data records whose generation has been prevented by the stopping signal.

## Claims

1. A communication system (100) comprising:
a first network node (200) and a second network node (300), wherein the first network node (200) is arranged to transmit a flow of data records to the second network node (300) via a network (500), and the second network node (300) comprises a data record processing module (600) arranged to receive and process the data records;
a controller (700) for controlling the transmission of data records by the first network node (200) to the second network node (300), the controller (700) comprising:
an acquisition module (710) operable to acquire data records of the flow of data records;
a pattern recognition module (720) arranged to determine whether the data records acquired by the acquisition module (710) match a part of a pattern of one or more patterns each defining a respective sequence of data records and, when the acquired data records match part of a pattern of the one or more patterns, to identify which of the one or more patterns the acquired data records match; and
a control signal generator module (730) arranged to generate, when the pattern recognition module (720) has identified a pattern matching the acquired data records, an indication of the matching pattern and at least one transmission control signal for the first network node (200) to prevent the first network node (200) from transmitting to the second network node (300) remaining data records in the flow that follow the acquired data records and whose number is equal to the number of data records in the remaining part of the matching pattern, the remaining part of the matching pattern being the part of the sequence of data records of the pattern other than the part found to match the acquired data records; and
a pattern handler (800) comprising a data store (820) that stores the one or more patterns, the pattern handler (800) being communicatively coupled to the data record processing module (600) via a communication path (900) that is separate from the network (500) and responsive to the indication of the matching pattern to predict the remaining data records using the pattern of the stored patterns that is indicated by the indication, and provide the predicted data records to the data record processing module (600) via the communication path (900).

2. A network node (300) operable to receive a flow of data records that has been transmitted by a second network node (200) via a network (500), the network node comprising:
a data record processing module (600) arranged to receive and process the data records;
a data store (820) that stores one or more patterns each defining a respective sequence of data records;
a controller (700) for controlling the transmission of data records by the second network node (200), the controller (700) comprising:
an acquisition module (710) operable to acquire data records of the flow of data records;
a pattern recognition module (720) arranged to determine whether the data records acquired by the acquisition module (710) match part of a pattern of the one or more patterns stored in the data store (820) and, when the acquired data records match part of a pattern of the one or more patterns, to identify which of the one or more patterns the acquired data records match; and
a control signal generator module (730) arranged to generate, when the pattern recognition module (720) has identified a pattern matching the acquired data records, an indication of the matching pattern and at least one transmission control signal for the second network node (200) to prevent the second network node (200) from transmitting remaining data records in the flow that follow the acquired data records and whose number is equal to the number of data records in the remaining part of the matching pattern, the remaining part of the matching pattern being the part of the sequence of data records of the pattern other than the part found to match the acquired data records; and
a pattern handler (800) responsive to the indication of the matching pattern to predict the remaining data records using the pattern of the stored patterns that is indicated by the indication of the matching pattern, and provide the predicted data records to the data record processing module (600).

3. A network node (300) according to claim 2, wherein the controller (700) further comprises a pattern learning module (760) operable to receive the flow of data records and arranged to search for an occurrence of a repeating sequence of data records that repeats at least once in the flow of data records and, in response to finding a repeating sequence of data records, to generate a pattern defining the repeating sequence of data records and store the generated pattern as one of the patterns in the data store (820).

4. A network node (300) according to any of claims 2 to 3, wherein the flow of data records comprises two or more parallel streams of data records, and each of the one or more patterns defines respective parallel sequences of data records, the pattern recognition module (720) being arranged to determine whether data records of a segment of the flow acquired by the acquisition module (710) match part of a pattern of the one or more patterns by comparing data records in each of the streams in the segment with a part of a corresponding one of the sequences of data records in the pattern, and determining that the data records in the segment match part of the pattern when the data records in each of the streams in the segment match the data records in the part of the corresponding one of the sequences of data records in the pattern.

5. A method of controlling the transmission of data records in a communication system (100) comprising:
a first network node (200) and a second network node (300), wherein the first network node (200) is arranged to transmit a flow of data records to the second network node (300) via a network (500), and the second network node (300) comprises a data record processing module (600) arranged to receive and process the data records; and
a pattern handler (800) comprising a data store that stores one or more patterns each defining a respective sequence of data records, the pattern handler (800) being communicatively coupled to the data record processing module (600) via a communication path (900) that is separate from the network (500), wherein the pattern handler (800) is responsive to an indication of a pattern to predict data records using a pattern of the stored patterns that is indicated by the indication, and to provide the predicted data records to the data record processing module (600) via the communication path (900),
the method comprising:
acquiring (S100) data records of the flow of data records;
determining (S200) whether the acquired data records match a part of a pattern of the one or more patterns; and
generating (S300), when the acquired data records have been determined to match a part of a pattern of the one or more patterns:
at least one transmission control signal for the first network node (200) to prevent the first network node (200) from transmitting to the second network node (300) remaining data records in the flow that follow the acquired data records and whose number is equal to the number of data records in the remaining part of the matching pattern, the remaining part of the matching pattern being the part of the sequence of data records of the pattern other than the part found to match the acquired data records; and
an indication of the matching pattern for use by the pattern handler (800) to predict the remaining data records.

6. The method according to claim 5, further comprising:
accessing a second data store (740) that stores each of the one or more patterns in association with a respective pattern identifier that identifies the respective pattern, and acquiring from the second data store (740) the patterns and associated pattern identifiers stored therein;
updating the data store (820) of the pattern handler (800) via the network (500) to store the one or more patterns and associated one or more pattern identifiers that have been acquired from the second data store (740);
identifying, when the acquired data records are determined to match a part of a pattern of the one or more patterns, the acquired pattern identifier that is associated with the matching pattern, the indication of the matching pattern being generated to comprise the pattern identifier associated with the matching pattern; and
transmitting the generated indication of the matching pattern via the network (500).

7. The method according to claim 6, wherein the pattern handler is arranged to receive data records transmitted by the first network node (200) to the second network node (300) and, in response to receiving one or more data records before the remaining data records have been predicted, to stop predicting the remaining data records and to provide the data record processing module (600) with the received one or more data records, the method further comprising:
generating reference data records using the identified pattern;
comparing the reference data records against data records whose transmission has been prevented to determine whether data records whose transmission has been prevented follow the identified pattern; and
when at least one data record whose transmission has been prevented is determined not to follow the identified pattern, causing the control signal generator (730) to control the first network node (200) to transmit to the second network node (300) the at least one data record whose transmission had been prevented and which was determined not to follow the identified pattern.

8. The method according to claim 6, further comprising, when the acquired data records have been determined to match a part of a pattern of the one or more patterns:
generating reference data records using the determined pattern;
comparing the reference data records against data records whose transmission has been prevented to determine whether data records whose transmission has been prevented follow the matching pattern; and
when at least one data record whose transmission has been prevented is determined not to follow the matching pattern:
generating and transmitting via the network (500) a stopping signal to stop the pattern handler (800) predicting data records; and
controlling the first network node (200) to transmit to the second network node (300) the at least one data record whose transmission had been prevented and which was determined not to follow the matching pattern,
such that the data record processing module (600) receives said data records instead of the corresponding predicted data records whose generation has been prevented by the stopping signal.

9. The method according to claim 7 or claim 8, wherein at least one data record whose transmission has been prevented is determined not to follow the matching pattern when each of the at least one data record differs from the corresponding reference data record by at least a respective predetermined amount.

10. The method according to any of claims 6 to 9, further comprising:
searching for an occurrence of a repeating sequence of data records that repeats at least once in the flow of data records; and
when a repeating sequence of data records is found:
generating a pattern defining the repeating sequence of data records; and
storing the generated pattern in association with a corresponding pattern identifier as one of the stored patterns and associated pattern identifier in the second data store (740).

11. The method according to any of claims 5 to 10, wherein:
determining whether the acquired data records match a part of a pattern of the one or more patterns comprises determining whether the acquired data records match a part of a pattern of a plurality of the patterns; and
when the acquired data records are determined to match part of a first of the patterns and part of each of one or more other of the patterns, the first pattern defining a shorter sequence of data records than each of the one or more other patterns, the first pattern is selected as the matching pattern.

12. The method according to any of claims 5 to 11, further comprising:
determining whether usage of network bandwidth available for communication between the first network node (200) and the second network node (300) exceeds a predetermined level,
wherein the at least one transmission control signal and the indication of the matching pattern are generated when the determined usage exceeds the predetermined level.

13. The method according to any of claims 5 to 12, wherein the flow of data records comprises two or more parallel streams of data records, and each of the one or more patterns defines respective parallel sequences of data records, and determining whether data records of a segment of the flow acquired by the acquisition module (710) match part of a pattern of the one or more patterns comprises comparing data records in each of the streams in the segment with a part of a corresponding one of the sequences of data records in the pattern, and determining that the data records in the segment match part of the pattern when the data records in each of the streams in the segment match the data records in the part of the corresponding one of the sequences of data records in the pattern.

14. A computer-readable storage medium (1500) storing computer program instructions which, when executed by at least one processor (1200), cause the at least one processor (1200) to perform a method as set out in at least one of claims 5 to 13.

15. A controller (700) for use in a communication system (100), the communication system (100) comprising:
a first network node (200) and a second network node (300), wherein the first network node (200) is arranged to transmit a flow of data records to the second network node (300) via a network (500), and the second network node (300) comprises a data record processing module (600) arranged to receive and process the data records; and
a pattern handler (800) comprising a data store (820) that stores one or more patterns each defining a respective sequence of data records, the pattern handler (800) being communicatively coupled to the data record processing module (600) via a communication path (900) that is separate from the network (500), wherein the pattern handler (800) is responsive to an indication of a pattern to predict data records using a pattern of the stored patterns that is indicated by the indication, and provide the predicted data records to the data record processing module (600) via the communication path (900),
wherein the controller (700) is arranged to control the transmission of data records by the first network node (200) to the second network node (300), and comprises:
an acquisition module (710) operable to acquire data records of the flow of data records;
a pattern recognition module (720) arranged to determine whether the data records acquired by the acquisition module (710) match part of a pattern of the one or more patterns and, when the acquired data records match part of a pattern of the one or more patterns, to identify which of the one or more patterns the acquired data records match; and
a control signal generator module (730) arranged to generate, when the pattern recognition module (720) has identified a pattern matching the acquired data records, at least one transmission control signal for the first network node (200) to prevent the first network node (200) from transmitting to the second network node (300) remaining data records in the flow that follow the acquired data records and whose number is equal to the number of data records in the remaining part of the matching pattern, and an indication of the matching pattern to cause the pattern handler (800) to predict the remaining data records and provide the predicted data records to the data record processing module (600) via the communication path (900), the remaining part of the matching pattern being the part of the sequence of data records of the pattern other than the part found to match the acquired data records.

16. The controller (700) according to claim 15, wherein:
the controller (700) is configured to perform the method of any of the claims 6 to 13.

## Patentansprüche

1. Kommunikationssystem (100), umfassend:
einen ersten Netzwerkknoten (200) und einen zweiten Netzwerkknoten (300), wobei der erste Netzwerkknoten (200) zum Senden eines Flusses von Datensätzen über ein Netzwerk (500) an den zweiten Netzwerkknoten (300) ausgelegt ist, und der zweite Netzwerkknoten (300) ein Datensatzverarbeitungsmodul (600) umfasst, das zum Empfangen und Verarbeiten der Datensätze ausgelegt ist;
eine Steuerung (700) zum Steuern der Übertragung von Datensätzen vom ersten Netzwerkknoten (200) an den zweiten Netzwerkknoten (300), wobei die Steuerung (700) umfasst:
ein Erfassungsmodul (710), das zum Erfassen von Datensätzen des Flusses von Datensätzen betrieben werden kann;
ein Mustererkennungsmodul (720), das so ausgelegt ist, dass es bestimmt, ob die vom Erfassungsmodul (710) erfassten Datensätze mit einem Teil eines Musters eines oder mehrerer Muster übereinstimmen, die jeweils eine jeweilige Folge von Datensätzen definieren, und, wenn die erfassten Datensätze mit einem Teil eines Musters des einen oder der mehreren Muster übereinstimmen, identifiziert, mit welchem des einen oder der mehreren Muster die erfassten Datensätze übereinstimmen; und
ein Steuersignalgeneratormodul (730), das so ausgelegt ist, dass es, wenn das Mustererkennungsmodul (720) ein Muster identifiziert hat, das mit den erfassten Datensätzen übereinstimmt, eine Anzeige des übereinstimmenden Musters und mindestens ein Übertragungssteuersignal für den ersten Netzwerkknoten (200) erzeugt, um zu verhindern, dass der erste Netzwerkknoten (200) restliche Datensätze im Fluss, die den erfassten Datensätzen folgen und deren Anzahl gleich der Anzahl von Datensätzen im restlichen Teil des übereinstimmenden Musters ist, an den zweiten Knoten (300) sendet, wobei der restliche Teil des übereinstimmenden Musters der andere Teil der Folge von Datensätzen des Musters ist als der Teil, der sich als mit den erfassten Datensätzen übereinstimmend erwies; und
einen Muster-Handler (800), der einen Datenspeicher (820) umfasst, der das eine oder die mehreren Muster speichert, wobei der Muster-Handler (800) mit dem Datensatzverarbeitungsmodul (600) über einen Kommunikationspfad (900), der vom Netzwerk (500) getrennt ist, kommunikativ gekoppelt ist und in Reaktion auf die Anzeige des übereinstimmenden Musters die restlichen Datensätze unter Verwendung des Musters der gespeicherten Muster, das durch die Anzeige angezeigt wird, vorhersagt und die vorhergesagten Datensätze über den Kommunikationspfad (900) für das Datensatzverarbeitungsmodul (600) bereitstellt.

2. Netzwerkknoten (300), der so betrieben werden kann, dass er einen Fluss von Datensätzen empfängt, die von einem zweiten Knoten (200) über ein Netzwerk (500) gesendet werden, wobei der Netzwerkknoten umfasst:
ein Datensatzverarbeitungsmodul (600), das zum Empfangen und Verarbeiten der Datensätze ausgelegt ist;
einen Datenspeicher (820), der das eine oder die mehreren Muster speichert, die jeweils eine jeweilige Folge von Datensätzen definieren;
eine Steuerung (700) zum Steuern der Übertragung von Datensätzen vom zweiten Netzwerkknoten (200), wobei die Steuerung (700) umfasst:
ein Erfassungsmodul (710), das zum Erfassen von Datensätzen des Flusses von Datensätzen betrieben werden kann;
ein Mustererkennungsmodul (720), das so ausgelegt ist, dass es bestimmt, ob die vom Erfassungsmodul (710) erfassten Datensätze mit einem Teil eines Musters des eines oder der mehreren Muster übereinstimmen, die im Datenspeicher (820) gespeichert sind, und, wenn die erfassten Datensätze mit einem Teil eines Musters des einen oder der mehreren Muster übereinstimmen, identifiziert, mit welchem des einen oder der mehreren Muster die erfassten Datensätze übereinstimmen; und
ein Steuersignalgeneratormodul (730), das so ausgelegt ist, dass es, wenn das Mustererkennungsmodul (720) ein Muster identifiziert hat, das mit den erfassten Datensätzen übereinstimmt, eine Anzeige des übereinstimmenden Musters und mindestens ein Übertragungssteuersignal für den zweiten Netzwerkknoten (200) erzeugt, um zu verhindern, dass der zweite Netzwerkknoten (200) restliche Datensätze im Fluss sendet, die den erfassten Datensätzen folgen und deren Anzahl gleich der Anzahl von Datensätzen im restlichen Teil des übereinstimmenden Musters ist, wobei der restliche Teil des übereinstimmenden Musters der andere Teil der Folge von Datensätzen des Musters ist als der Teil, der sich als mit den erfassten Datensätzen übereinstimmend erwies; und
einen Muster-Handler (800), der in Reaktion auf die Anzeige des übereinstimmenden Musters die restlichen Datensätze unter Verwendung des Musters der gespeicherten Muster, das durch die Anzeige angezeigt wird, vorhersagt und die vorhergesagten Datensätze für das Datensatzverarbeitungsmodul (600) bereitstellt.

3. Netzwerkknoten (300) nach Anspruch 2, wobei die Steuerung (700) ferner ein Musterlernmodul (760) umfasst, das betrieben werden kann, um den Fluss von Datensätzen zu empfangen, und so ausgelegt ist, dass es nach einem Auftreten einer sich wiederholenden Folge von Datensätzen sucht, die sich im Fluss die Datensätzen mindestens einmal wiederholt, und in Reaktion auf ein Auffinden einer sich wiederholenden Folge von Datensätzen ein Muster erzeugt, das die sich wiederholende Folge von Datensätzen definiert, und das erzeugte Muster als eines der Muster im Datenspeicher (820) speichert.

4. Netzwerkknoten (300) nach einem der Ansprüche 2 bis 3, wobei der Fluss von Datensätzen zwei oder mehr parallele Ströme von Datensätzen umfasst, und jedes des einen oder der mehreren Muster eine jeweilige parallele Folge von Datensätzen definiert, wobei das Mustererkennungsmodul (720) so ausgelegt ist, dass es bestimmt, ob Datensätze eines Segments des Flusses, die vom Erfassungsmodul (710) erfasst werden, mit einem Teil eines Musters des einen oder der mehreren Muster übereinstimmen, indem es Datensätze in jedem der Ströme im Segment mit einem Teil einer entsprechenden der Folgen von Datensätzen im Muster vergleicht und bestimmt, dass die Datensätze im Segment mit einem Teil des Musters übereinstimmen, wenn die Datensätze in jedem der Ströme im Segment mit den Datensätzen im Teil der entsprechenden der Folgen von Datensätzen im Muster übereinstimmen.

5. Verfahren zur Steuerung der Übertragung von Datensätzen in einem Kommunikationssystem (100), umfassend:
einen ersten Netzwerkknoten (200) und einen zweiten Netzwerkknoten (300), wobei der erste Netzwerkknoten (200) zum Senden eines Flusses von Datensätzen über ein Netzwerk (500) an den zweiten Netzwerkknoten (300) ausgelegt ist, und der zweite Netzwerkknoten (300) ein Datensatzverarbeitungsmodul (600) umfasst, das zum Empfangen und Verarbeiten der Datensätze ausgelegt ist; und
einen Muster-Handler (800), der einen Datenspeicher umfasst, der ein oder mehrere Muster speichert, die jeweils eine jeweilige Folge von Datensätzen definieren, wobei der Muster-Handler (800) mit dem Datensatzverarbeitungsmodul (600) über einen Kommunikationspfad (900), der vom Netzwerk (500) getrennt ist, kommunikativ gekoppelt ist, wobei der Muster-Handler (800) in Reaktion auf eine Anzeige eines Musters Datensätze unter Verwendung eines Musters der gespeicherten Muster, das durch die Anzeige angezeigt wird, vorhersagt und die vorhergesagten Datensätze über den Kommunikationspfad (900) für das Datensatzverarbeitungsmodul (600) bereitstellt,
wobei das Verfahren umfasst:
Erfassen (S100) von Datensätzen des Flusses von Datensätzen;
Bestimmen (S200), ob die erfassten Datensätze mit einem Teil eines Musters des einen oder mehreren Muster übereinstimmen; und
Erzeugen (S300), wenn bestimmt wurde, dass die erfassten Datensätze mit einem Teil eines Musters des einen oder mehreren Muster übereinstimmen:
mindestens eines Übertragungssteuersignals für den ersten Netzwerkknoten (200), um zu verhindern, dass der erste Netzwerkknoten (200) restliche Datensätze im Fluss, die den erfassten Datensätzen folgen und deren Anzahl gleich der Anzahl von Datensätzen im restlichen Teil des übereinstimmenden Musters ist, an den zweiten Knoten (300) sendet, wobei der restliche Teil des übereinstimmenden Musters der andere Teil der Folge von Datensätzen des Musters ist als der Teil, der sich als mit den erfassten Datensätzen übereinstimmend erwies; und
einer Anzeige des übereinstimmenden Musters zur Verwendung durch den Muster-Handler (800) zum Vorhersagen der restlichen Datensätze.

6. Verfahren nach Anspruch 5, ferner umfassend:
Zugreifen auf einen zweiten Datenspeicher (740), der jedes des einen oder der mehreren Muster in Assoziation mit einer jeweiligen Musterkennung speichert, die das jeweilige Muster identifiziert, und Abrufen aus dem zweiten Datenspeicher (740) der Muster und der assoziierten Musterkennungen, die darin gespeichert sind;
Aktualisieren des Datenspeichers (820) des Muster-Handlers (800) über das Netzwerk (500), um das eine oder die mehreren Muster und die eine oder die mehreren assoziierten Musterkennungen zu speichern, die aus dem zweiten Datenspeicher (740) abgerufen wurden;
Identifizieren, wenn bestimmt wird, das die erfassten Datensätze mit einem Teil eines Musters des einen oder der mehreren Muster übereinstimmen, der abgerufenen Musterkennung, die mit dem übereinstimmenden Muster assoziiert ist, wobei die Anzeige des übereinstimmenden Musters so erzeugt wird, dass sie die Musterkennung umfasst, die mit dem übereinstimmenden Muster assoziiert ist; und
Senden der erzeugten Anzeige des übereinstimmenden Musters über das Netzwerk (500).

7. Verfahren nach Anspruch 6, wobei der Muster-Handler so ausgelegt ist, dass er Datensätze empfängt, die vom ersten Netzwerkknoten (200) an den zweiten Netzwerkknoten (300) gesendet werden, und in Reaktion auf ein Empfangen eines oder mehrerer Datensätze, bevor die restlichen Datensätze vorhergesagt wurden, das Vorhersagen der restlichen Datensätze stoppt und das Datensatzverarbeitungsmodul (600) mit dem einen oder den mehreren empfangenen Datensätzen versieht, wobei das Verfahren ferner umfasst:
Erzeugen von Referenzdatensätzen unter Verwendung des identifizierten Musters;
Vergleichen der Referenzdatensätze mit Datensätzen, deren Übertragung verhindert wurde, um zu bestimmen, ob Datensätze, deren Übertragung verhindert wurde, das identifizierte Muster befolgen; und
Bewirken, dass, wenn bestimmt wird, dass mindestens ein Datensatz, dessen Übertragung verhindert wurde, das identifizierte Muster nicht befolgt, der Steuersignalgenerator (730) den ersten Netzwerkknoten (200) so steuert, dass er den mindestens einen Datensatz, dessen Übertragung verhindert wurde und von dem bestimmt wurde, dass er das identifizierte Muster nicht befolgt, an den zweiten Netzwerkknoten (300) sendet.

8. Verfahren nach Anspruch 6, ferner umfassend, wenn bestimmt wurde, dass die erfassten Datensätze mit einem Teil eines Musters des einen oder mehreren Muster übereinstimmen:
Erzeugen von Referenzdatensätzen unter Verwendung des bestimmten Musters;
Vergleichen der Referenzdatensätze mit Datensätzen, deren Übertragung verhindert wurde, um zu bestimmen, ob Datensätze, deren Übertragung verhindert wurde, das übereinstimmende Muster befolgen; und
wenn bestimmt wird, dass mindestens ein Datensatz, dessen Übertragung verhindert wurde, das übereinstimmende Muster nicht befolgt:
Erzeugen und Senden eines Stoppsignals über das Netzwerk (500), damit der Muster-Handler (800) das Vorhersagen von Datensätzen stoppt; und
derartiges Steuern des ersten Netzwerkknotens (200), dass er den mindestens einen Datensatz, dessen Übertragung verhindert wurde und von dem bestimmt wurde, dass er das übereinstimmende Muster nicht befolgt, an den zweiten Netzwerkknoten (300) sendet,
derart dass das Datensatzverarbeitungsmodul (600) die Datensätze anstelle der entsprechenden vorgesagten Datensätze empfängt, deren Erzeugung durch das Stoppsignal verhindert wurde.

9. Verfahren nach Anspruch 7 oder 8, wobei bestimmt wird, dass mindestens ein Datensatz, dessen Übertragung verhindert wurde, das übereinstimmende Muster nicht befolgt, wenn sich jeder des mindestens einen Datensatzes vom entsprechenden Referenzdatensatz um mindestens eine jeweilige vorbestimmte Menge unterscheidet.

10. Verfahren nach einem der Ansprüche 6 bis 9, ferner umfassend:
Suchen nach einem Auftreten einer sich wiederholenden Folge von Datensätzen, die sich im Fluss von Datensätzen mindestens einmal wiederholt; und
wenn eine sich wiederholende Folge von Datensätzen gefunden wird:
Erzeugen eines Musters, das die sich wiederholende Folge von Datensätzen definiert; und
Speichern des erzeugten Musters in Assoziation mit einer entsprechenden Musterkennung als eines der gespeicherten Muster und der assoziierten Musterkennung im zweiten Datenspeicher (740).

11. Verfahren nach einem der Ansprüche 5 bis 10, wobei:
das Bestimmen, ob die erfassten Datensätze mit einem Teil eines Musters des einen oder der mehreren Muster übereinstimmen, ein Bestimmen umfasst, ob die erfassten Datensätze mit einem Teil eines Musters einer Mehrzahl von Mustern übereinstimmen; und,
wenn bestimmt wird, dass die erfassten Datensätze mit einem Teil eines ersten der Muster und einem Teil eines jeden von einem oder mehreren anderen der Muster übereinstimmen, wobei das erste Muster eine kürzere Folge von Datensätzen als jedes des einen oder der mehreren anderen Muster aufweist, das erste Muster als das übereinstimmende Muster ausgewählt wird.

12. Verfahren nach einem der Ansprüche 5 bis 11, ferner umfassend:
Bestimmen, ob eine Nutzung von Netzwerkbandbreite, die zur Kommunikation zwischen dem ersten Netzwerkknoten (200) und dem zweiten Netzwerkknoten (300) verfügbar ist, einen vorbestimmten Grad überschreitet,
wobei das mindestens eine Übertragungssteuersignal und die Anzeige des übereinstimmenden Musters erzeugt werden, wenn die bestimmte Nutzung den vorbestimmten Grad überschreitet.

13. Verfahren nach einem der Ansprüche 5 bis 12, wobei der Fluss von Datensätzen zwei oder mehr parallele Ströme von Datensätzen umfasst, und jedes des einen oder der mehreren Muster eine jeweilige parallele Folge von Datensätzen definiert, und das Bestimmen, ob Datensätze eines Segments des Flusses, die vom Erfassungsmodul (710) erfasst werden, mit einem Teil eines Musters des einen oder der mehreren Muster übereinstimmen, ein Vergleichen von Datensätzen in jedem der Ströme im Segment mit einem Teil einer entsprechenden der Folgen von Datensätzen im Muster und Bestimmen umfasst, dass die Datensätze im Segment mit einem Teil des Musters übereinstimmen, wenn die Datensätze in jedem der Ströme im Segment mit den Datensätzen im Teil der entsprechenden der Folgen von Datensätzen im Muster übereinstimmen.

14. Computerlesbares Speichermedium (1500), das Computerprogrammanweisungen speichert, die bei Ausführung durch mindestens einen Prozessor (1200) den mindestens Prozessor (1200) zum Durchführen eines Verfahrens nach mindestens einem der Ansprüche 5 bis 13 veranlassen.

15. Steuerung (700) zur Verwendung in einem Kommunikationssystem (100), wobei das Kommunikationssystem (100) umfasst:
einen ersten Netzwerkknoten (200) und einen zweiten Netzwerkknoten (300), wobei der erste Netzwerkknoten (200) zum Senden eines Flusses von Datensätzen über ein Netzwerk (500) an den zweiten Netzwerkknoten (300) ausgelegt ist, und der zweite Netzwerkknoten (300) ein Datensatzverarbeitungsmodul (600) umfasst, das zum Empfangen und Verarbeiten der Datensätze ausgelegt ist; und
einen Muster-Handler (800), der einen Datenspeicher (820) umfasst, der ein oder mehrere Muster speichert, die jeweils eine jeweilige Folge von Datensätzen definieren, wobei der Muster-Handler (800) mit dem Datensatzverarbeitungsmodul (600) über einen Kommunikationspfad (900), der vom Netzwerk (500) getrennt ist, kommunikativ gekoppelt ist, wobei der Muster-Handler (800) in Reaktion auf eine Anzeige eines Musters Datensätze unter Verwendung eines Musters der gespeicherten Muster, das durch die Anzeige angezeigt wird, vorhersagt und die vorhergesagten Datensätze über den Kommunikationspfad (900) für das Datensatzverarbeitungsmodul (600) bereitstellt,
wobei Steuerung (700) zum Steuern der Übertragung von Datensätzen vom ersten Netzwerkknoten (200) an den zweiten Netzwerkknoten (300) ausgelegt ist und umfasst:
ein Erfassungsmodul (710), das zum Erfassen von Datensätzen des Flusses von Datensätzen betrieben werden kann;
ein Mustererkennungsmodul (720), das so ausgelegt ist, dass es bestimmt, ob die vom Erfassungsmodul (710) erfassten Datensätze mit einem Teil eines Musters des eines oder der mehreren Muster übereinstimmen, und, wenn die erfassten Datensätze mit einem Teil eines Musters des einen oder der mehreren Muster übereinstimmen, identifiziert, mit welchem des einen oder der mehreren Muster die erfassten Datensätze übereinstimmen; und
ein Steuersignalgeneratormodul (730), das so ausgelegt ist, dass es, wenn das Mustererkennungsmodul (720) ein Muster identifiziert hat, das mit den erfassten Datensätzen übereinstimmt, mindestens ein Übertragungssteuersignal für den ersten Netzwerkknoten (200) zum Verhindern, dass der erste Netzwerkknoten (200) restliche Datensätze im Fluss, die den erfassten Datensätzen folgen und deren Anzahl gleich der Anzahl von Datensätzen im restlichen Teil des übereinstimmenden Musters ist, an den zweiten Knoten (300) sendet, und eine Anzeige des übereinstimmenden Musters erzeugt, um den Muster-Handler (800) zu veranlassen, die restlichen Datensätze vorherzusagen und die vorhergesagten Datensätze über den Kommunikationspfad (900) für das Datensatzverarbeitungsmodul (600) bereitzustellen, wobei der restliche Teil des übereinstimmenden Musters der andere Teil der Folge von Datensätzen des Musters ist als der Teil, der sich als mit den erfassten Datensätzen übereinstimmend erwies.

16. Steuerung (700) nach Anspruch 15, wobei:
die Steuerung (700) zum Durchführen des Verfahrens nach einem der Ansprüche 6 bis 13 konfiguriert ist.

## Revendications

1. Système de communication (100) comprenant :
un premier noeud de réseau (200) et un deuxième noeud de réseau (300), dans lequel le premier noeud de réseau (200) est agencé pour la transmission d'un flux d'enregistrements de données à destination du deuxième noeud de réseau (300) par l'intermédiaire d'un réseau (500), et le deuxième noeud de réseau (300) comprend un module de traitement d'enregistrement de données (600) agencé pour la réception et le traitement des enregistrements de données ;
un organe de commande (700) pour la commande de la transmission d'enregistrements de données par le premier noeud de réseau (200) à destination du deuxième noeud de réseau (300), l'organe de commande (700) comprenant :
un module d'acquisition (710) utilisable pour l'acquisition d'enregistrements de données du flux d'enregistrements de données ;
un module de reconnaissance de motif (720) agencé pour la détermination si les enregistrements de données acquis par le module d'acquisition (710) correspondent à une partie d'un motif d'un ou plusieurs motifs, chacun d'eux définissant une séquence respective d'enregistrements de données et, lorsque les enregistrements de données acquis correspondent à une partie d'un motif de l'un ou plusieurs motifs, l'identification de celui de l'un ou plusieurs motifs auquel les enregistrements de données acquis correspondent ; et
un module de génération de signal de commande (730) agencé pour la génération, lorsque le module de reconnaissance de motif (720) a identifié un motif correspondant aux enregistrements de données acquis, d'une indication du motif correspondant et d'au moins un signal de commande de transmission pour le premier noeud de réseau (200) afin d'empêcher que le premier noeud de réseau (200) ne transmette, à destination du deuxième noeud de réseau (300), des enregistrements de données restants dans le flux qui suivent les enregistrements de données acquis et dont le nombre est égal au nombre d'enregistrements de données dans la partie restante du motif correspondant, la partie restante du motif correspondant étant la partie de la séquence d'enregistrements de données du motif autre que la partie s'avérant correspondre aux enregistrements de données acquis ; et
un gestionnaire de motif (800) comprenant une mémoire de données (820) qui mémorise l'un ou plusieurs motifs, le gestionnaire de motif (800) étant couplé, de manière à pouvoir communiquer, au module de traitement d'enregistrement de données (600) par l'intermédiaire d'une voie de communication (900) distincte du réseau (500) et réactif à l'indication du motif correspondant pour prédire les enregistrements de données restants en utilisant le motif des motifs mémorisés qui est indiqué par l'indication, et fournir les enregistrements de données prédits au module de traitement d'enregistrement de données (600) par l'intermédiaire de la voie de communication (900).

2. Noeud de réseau (300) utilisable pour la réception d'un flux d'enregistrements de données qui a été transmis par un deuxième noeud de réseau (200) par l'intermédiaire d'un réseau (500), le noeud de réseau comprenant :
un module de traitement d'enregistrement de données (600) agencé pour la réception et le traitement des enregistrements de données ;
une mémoire de données (820) qui mémorise un ou plusieurs motifs, chacun d'eux définissant une séquence respective d'enregistrements de données ;
un organe de commande (700) pour la commande de la transmission d'enregistrements de données par le deuxième noeud de réseau (200), l'organe de commande (700) comprenant :
un module d'acquisition (710) utilisable pour l'acquisition d'enregistrements de données du flux d'enregistrements de données ;
un module de reconnaissance de motif (720) agencé pour la détermination si les enregistrements de données acquis par le module d'acquisition (710) correspondent à une partie d'un motif de l'un ou plusieurs motifs mémorisés dans la mémoire de données (820) et, lorsque les enregistrements de données acquis correspondent à une partie d'un motif de l'un ou plusieurs motifs, l'identification de celui de l'un ou plusieurs motifs auquel les enregistrements de données acquis correspondent ; et
un module de génération de signal de commande (730) agencé pour la génération, lorsque le module de reconnaissance de motif (720) a identifié un motif correspondant aux enregistrements de données acquis, d'une indication du motif correspondant et d'au moins un signal de commande de transmission pour le deuxième noeud de réseau (200) afin d'empêcher que le deuxième noeud de réseau (200) ne transmette des enregistrements de données restants dans le flux qui suivent les enregistrements de données acquis et dont le nombre est égal au nombre d'enregistrements de données dans la partie restante du motif correspondant, la partie restante du motif correspondant étant la partie de la séquence d'enregistrements de données du motif autre que la partie s'avérant correspondre aux enregistrements de données acquis ; et
un gestionnaire de motif (800) réactif à l'indication du motif correspondant pour prédire les enregistrements de données restants en utilisant le motif des motifs mémorisés qui est indiqué par l'indication du motif correspondant, et fournir les enregistrements de données prédits au module de traitement d'enregistrement de données (600).

3. Noeud de réseau (300) selon la revendication 2, dans lequel l'organe de commande (700) comprend en outre un module d'apprentissage de motif (760) utilisable pour recevoir le flux d'enregistrements de données et agencé pour rechercher une occurrence d'une séquence répétitive d'enregistrements de données qui se répète au moins une fois dans le flux d'enregistrements de données et, en réponse à la découverte d'une séquence répétitive d'enregistrements de données, générer un motif définissant la séquence répétitive d'enregistrements de données et mémoriser le motif généré en tant que l'un des motifs dans la mémoire de données (820).

4. Noeud de réseau (300) selon l'une quelconque des revendications 2 et 3, dans lequel le flux d'enregistrements de données comprend au moins deux flots parallèles d'enregistrements de données, et chacun de l'un ou plusieurs motifs définit des séquences parallèles respectives d'enregistrements de données, le module de reconnaissance de motif (720) étant agencé pour déterminer si des enregistrements de données d'un segment du flux acquis par le module d'acquisition (710) correspondent à une partie d'un motif de l'un ou plusieurs motifs par la comparaison d'enregistrements de données dans chacun des flots dans le segment à une partie de l'une correspondante des séquences d'enregistrements de données dans le motif, et la détermination que les enregistrements de données dans le segment correspondent à une partie du motif lorsque les enregistrements de données dans chacun des flots dans le segment correspondent aux enregistrements de données dans la partie de l'une correspondante des séquences d'enregistrements de données dans le motif.

5. Procédé de commande de la transmission d'enregistrements de données dans un système de communication (100) comprenant :
un premier noeud de réseau (200) et un deuxième noeud de réseau (300), dans lequel le premier noeud de réseau (200) est agencé pour la transmission d'un flux d'enregistrements de données à destination du deuxième noeud de réseau (300) par l'intermédiaire d'un réseau (500), et le deuxième noeud de réseau (300) comprend un module de traitement d'enregistrement de données (600) agencé pour la réception et le traitement des enregistrements de données ; et
un gestionnaire de motif (800) comprenant une mémoire de données qui mémorise un ou plusieurs motifs, chacun d'eux définissant une séquence respective d'enregistrements de données, le gestionnaire de motif (800) étant couplé, de manière à pouvoir communiquer, au module de traitement d'enregistrement de données (600) par l'intermédiaire d'une voie de communication (900) distincte du réseau (500), dans lequel le gestionnaire de motif (800) est réactif à une indication d'un motif pour prédire des enregistrements de données en utilisant un motif des motifs mémorisés qui est indiqué par l'indication, et fournir les enregistrements de données prédits au module de traitement d'enregistrement de données (600) par l'intermédiaire de la voie de communication (900),
le procédé comprenant :
l'acquisition (S100) d'enregistrements de données du flux d'enregistrements de données ;
la détermination (S200) si les enregistrements de données acquis correspondent à une partie d'un motif de l'un ou plusieurs motifs ; et
la génération (S300), lorsqu'il est déterminé que les enregistrements de données acquis correspondent à une partie d'un motif de l'un ou plusieurs motifs :
d'au moins un signal de commande de transmission pour le premier noeud de réseau (200) afin d'empêcher que le premier noeud de réseau (200) ne transmette, à destination du deuxième noeud de réseau (300), des enregistrements de données restants dans le flux qui suivent les enregistrements de données acquis et dont le nombre est égal au nombre d'enregistrements de données dans la partie restante du motif correspondant, la partie restante du motif correspondant étant la partie de la séquence d'enregistrements de données du motif autre que la partie s'avérant correspondre aux enregistrements de données acquis ; et
d'une indication du motif correspondant à utiliser par le gestionnaire de motif (800) pour prédire les enregistrements de données restants.

6. Procédé selon la revendication 5, comprenant en outre :
l'accès à une deuxième mémoire de données (740) qui mémorise chacun de l'un ou plusieurs motifs en association avec un identifiant de motif respectif qui identifie le motif respectif, et l'acquisition, depuis la deuxième mémoire de données (740), des motifs et des identifiants de motifs associés qui sont mémorisés dans celle-ci ;
la mise à jour de la mémoire de données (820) du gestionnaire de motif (800) par l'intermédiaire du réseau (500) pour mémoriser l'un ou plusieurs motifs et l'un ou plusieurs identifiants de motifs associés qui ont été acquis depuis la deuxième mémoire de données (740) ;
l'identification, lorsqu'il est déterminé que les enregistrements de données acquis correspondent à une partie d'un motif de l'un ou plusieurs motifs, de l'identifiant de motif acquis qui est associé au motif correspondant, l'indication du motif correspondant étant générée pour comprendre l'identifiant de motif associé au motif correspondant ; et
la transmission de l'indication générée du motif correspondant par l'intermédiaire du réseau (500).

7. Procédé selon la revendication 6, dans lequel le gestionnaire de motif est agencé pour la réception d'enregistrements de données transmis par le premier noeud de réseau (200) au deuxième noeud de réseau (300) et, en réponse à la réception d'un ou plusieurs enregistrements de données avant que les enregistrements de données restants n'aient été prédits, l'arrêt de la prédiction des enregistrements de données restants et la fourniture, au module de traitement d'enregistrement de données (600), de l'un ou plusieurs enregistrements de données reçus, le procédé comprenant en outre :
la génération d'enregistrements de données de référence en utilisant le motif identifié ;
la comparaison des enregistrements de données de référence à des enregistrements de données dont la transmission a été empêchée pour déterminer si des enregistrements de données dont la transmission a été empêchée suivent le motif identifié ; et
lorsqu'il est déterminé qu'au moins un enregistrement de données dont la transmission a été empêchée ne suit pas le motif identifié, l'instruction au générateur de signal de commande (730) de commander au premier noeud de réseau (200) de transmettre, au deuxième noeud de réseau (300), l'au moins un enregistrement de données dont la transmission a été empêchée et pour lequel il a été déterminé qu'il ne suit pas le motif identifié.

8. Procédé selon la revendication 6, comprenant en outre, lorsqu'il est déterminé que les enregistrements de données acquis ne correspondent pas à une partie d'un motif de l'un ou plusieurs motifs :
la génération d'enregistrements de données de référence en utilisant le motif déterminé ;
la comparaison des enregistrements de données de référence à des enregistrements de données dont la transmission a été empêchée pour déterminer si des enregistrements de données dont la transmission a été empêchée suivent le motif correspondant ; et
lorsqu'il est déterminé qu'au moins un enregistrement de données dont la transmission a été empêchée ne suit pas le motif correspondant :
la génération et la transmission, par l'intermédiaire du réseau (500), d'un signal d'arrêt pour arrêter la prédiction d'enregistrements de données par le gestionnaire de motif (800) ; et
la commande au premier noeud de réseau (200) de transmettre, au deuxième noeud de réseau (300), l'au moins un enregistrement de données dont la transmission a été empêchée et pour lequel il a été déterminé qu'il ne suit pas le motif correspondant,
de sorte que le module de traitement d'enregistrement de données (600) reçoive lesdits enregistrements de données au lieu des enregistrements de données prédits correspondants dont la génération a été empêchée par le signal d'arrêt.

9. Procédé selon la revendication 7 ou 8, dans lequel il est déterminé qu'au moins un enregistrement de données dont la transmission a été empêchée ne suit pas le motif correspondant lorsque chacun de l'au moins un enregistrement de données diffère de l'enregistrement de données de référence correspondant d'au moins une quantité prédéterminée respective.

10. Procédé selon l'une quelconque des revendications 6 à 9, comprenant en outre :
la recherche d'une occurrence d'une séquence répétitive d'enregistrements de données qui se répète au moins une fois dans le flux d'enregistrements de données ; et
lorsqu'une séquence répétitive d'enregistrements de données est trouvée :
la génération d'un motif définissant la séquence répétitive d'enregistrements de données ; et
la mémorisation du motif généré en association avec un identifiant de motif correspondant en tant que l'un des motifs mémorisés et un identifiant de motif associé dans la deuxième mémoire de données (740).

11. Procédé selon l'une quelconque des revendications 5 à 10, dans lequel :
la détermination si les enregistrements de données acquis correspondent à une partie d'un motif de l'un ou plusieurs motifs comprend la détermination si les enregistrements de données acquis correspondent à une partie d'un motif d'une pluralité des motifs ; et
lorsqu'il est déterminé que les enregistrements de données acquis correspondent à une partie d'un premier des motifs et à une partie de chacun de l'un ou plusieurs autres des motifs, le premier motif définissant une séquence d'enregistrements de données plus courte que celle de chacun de l'un ou plusieurs autres motifs, le premier motif est sélectionné en tant que le motif correspondant.

12. Procédé selon l'une quelconque des revendications 5 à 11, comprenant en outre :
la détermination si une utilisation d'une largeur de bande de réseau disponible pour une communication entre le premier noeud de réseau (200) et le deuxième noeud de réseau (300) dépasse un niveau prédéterminé,
dans lequel l'au moins un signal de commande de transmission et l'indication du motif correspondant sont générés lorsque l'utilisation déterminée dépasse le niveau prédéterminé.

13. Procédé selon l'une quelconque des revendications 5 à 12, dans lequel le flux d'enregistrements de données comprend au moins deux flots parallèles d'enregistrements de données, et chacun de l'un ou plusieurs motifs définit des séquences parallèles respectives d'enregistrements de données, et la détermination si des enregistrements de données d'un segment du flux acquis par le module d'acquisition (710) correspondent à une partie d'un motif de l'un ou plusieurs motifs comprend la comparaison d'enregistrements de données dans chacun des flots dans le segment à une partie de l'une correspondante des séquences d'enregistrements de données dans le motif, et la détermination que les enregistrements de données dans le segment correspondent à une partie du motif lorsque les enregistrements de données dans chacun des flots dans le segment correspondent aux enregistrements de données dans la partie de l'une correspondante des séquences d'enregistrements de données dans le motif.

14. Support de mémorisation lisible par ordinateur (1500) mémorisant des instructions de programme informatique qui, lorsqu'elles sont exécutées par au moins un processeur (1200), amènent l'au moins un processeur (1200) à effectuer un procédé selon au moins l'une des revendications 5 à 13.

15. Organe de commande (700) destiné à être utilisé dans un système de communication (100), le système de communication (100) comprenant :
un premier noeud de réseau (200) et un deuxième noeud de réseau (300), dans lequel le premier noeud de réseau (200) est agencé pour la transmission d'un flux d'enregistrements de données à destination du deuxième noeud de réseau (300) par l'intermédiaire d'un réseau (500), et le deuxième noeud de réseau (300) comprend un module de traitement d'enregistrement de données (600) agencé pour la réception et le traitement des enregistrements de données ; et
un gestionnaire de motif (800) comprenant une mémoire de données (820) qui mémorise un ou plusieurs motifs, chacun d'eux définissant une séquence respective d'enregistrements de données, le gestionnaire de motif (800) étant couplé, de manière à pouvoir communiquer, au module de traitement d'enregistrement de données (600) par l'intermédiaire d'une voie de communication (900) distincte du réseau (500), dans lequel le gestionnaire de motif (800) est réactif à une indication d'un motif pour prédire des enregistrements de données en utilisant un motif des motifs mémorisés qui est indiqué par l'indication, et fournir les enregistrements de données prédits au module de traitement d'enregistrement de données (600) par l'intermédiaire de la voie de communication (900),
dans lequel l'organe de commande (700) est agencé pour commander la transmission d'enregistrements de données par le premier noeud de réseau (200) au deuxième noeud de réseau (300), et comprend :
un module d'acquisition (710) utilisable pour l'acquisition d'enregistrements de données du flux d'enregistrements de données ;
un module de reconnaissance de motif (720) agencé pour la détermination si les enregistrements de données acquis par le module d'acquisition (710) correspondent à une partie d'un motif de l'un ou plusieurs motifs, et, lorsque les enregistrements de données acquis correspondent à une partie d'un motif de l'un ou plusieurs motifs, l'identification de celui de l'un ou plusieurs motifs auquel les enregistrements de données acquis correspondent ; et
un module de génération de signal de commande (730) agencé pour la génération, lorsque le module de reconnaissance de motifs (720) a identifié un motif correspondant aux enregistrements de données acquis, d'au moins un signal de commande de transmission pour le premier noeud de réseau (200) afin d'empêcher que le premier noeud de réseau (200) ne transmette, à destination du deuxième noeud de réseau (300), des enregistrements de données restants dans le flux qui suivent les enregistrements de données acquis et dont le nombre est égal au nombre d'enregistrements de données dans la partie restante du motif correspondant, et une indication du motif correspondant pour amener le gestionnaire de motif (800) à prédire les enregistrements de données restants et fournir les enregistrements de données prédits au module de traitement d'enregistrement de données (600) par l'intermédiaire de la voie de communication (900), la partie restante du motif correspondant étant la partie de la séquence d'enregistrements de données du motif autre que la partie s'avérant correspondre aux enregistrements de données acquis.

16. Organe de commande (700) selon la revendication 15, dans lequel :
l'organe de commande (700) est configuré pour effectuer le procédé selon l'une quelconque des revendications 6 à 13.
